(19) Europäisches Patentamt
European Patent Office
Office européen des brevets

(11) EP 0 612 447 B1

(12) EUROPÄISCHE PATENTSCHRIFT

(45) Veröffentlichungstag und Bekanntmachung des Hinweises auf die Patenterteilung:
**29.10.1997 Patentblatt 1997/44**

(21) Anmeldenummer: **93919204.3**

(22) Anmeldetag: **27.08.1993**

(51) Int Cl.$^6$: **H03H 21/00**

(86) Internationale Anmeldenummer:
**PCT/EP93/02324**

(87) Internationale Veröffentlichungsnummer:
**WO 94/07308 (31.03.1994 Gazette 1994/08)**

# (54) ADAPTIVES FILTER

ADAPTIVE FILTER

FILTRE ADAPTATIF

(84) Benannte Vertragsstaaten:
**ES FR GB IT**

(30) Priorität: **16.09.1992 DE 4231005**
**06.08.1993 DE 4326487**

(43) Veröffentlichungstag der Anmeldung:
**31.08.1994 Patentblatt 1994/35**

(73) Patentinhaber: **INRIA INSTITUT NATIONAL DE RECHERCHE EN INFORMATIQUE ET EN AUTOMATIQUE**
**78153 Le Chesnay (FR)**

(72) Erfinder: **INRIA INSTITUT NATIONAL DE RECHERCHE EN INFORMATIQUE ET EN AUTOMATIQUE**
**78153 Le Chesnay (FR)**

(74) Vertreter: **Grünecker, Kinkeldey,**
**Stockmair & Schwanhäusser Anwaltssozietät**
**Maximilianstrasse 58**
**80538 München (DE)**

(56) Entgegenhaltungen:
- **24 th ASILOMAR CONF. 0N SIGNALS, SYSTEMS & 5-7/11/90; CALIFORNIA (US); P233- 236; S.K. MITRA et al: STRUCTURAL SUBBAND IMPLEMENTATION OF ADAPTIVE FILTERS**
- **IEEE TRANSACTIONS ON CIRCUITS AND SYSTEMS Bd. 31, Nr. 9 , September 1984 , NEW YORK US Seiten 801 - 805 AHMED ABO-TALEB ET AL 'DESIGN OF FIR TWO-DIMENSIONAL DIGITAL FILTERS BY SUCCESSIVE PROJECTIONS'**

EP 0 612 447 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

Printed by Jouve, 75001 PARIS (FR)

## Beschreibung

Die vorliegende Erfindung betrifft ein adaptives Filter zum Approximieren einer Sollwertfunktion F.

Die Erfindung befaßt sich insbesondere mit einem adaptiven Filter, das in der Lage ist, vorgegebene Sollwertfunktionen zu approximieren, um dadurch komplizierte Funktionen einfacher handhaben zu können, und für weitere Verarbeitungsschritte mit reduzierter Informationsbandbreite zur Verfügung zu stellen. Auch bezieht sich die vorliegende Erfindung auf spezielle Einrichtungen und Verfahren, die mittels derartiger adaptiver Filter ermöglicht werden, wobei derartige Verfahren und Einrichtungen in erster Linie im Bereich der Mustererkennung liegen.

Figur 14 zeigt, wie eine vorgegebene Sollwertfunktion F durch eine bandbreitesparende approximierte Funfktion $F_{app}$ annäherungsweise beschrieben werden kann.

Das Auffinden derartiger angenäherter Lösungen war im Stand der Technik mit großem Rechenaufwand verbunden und die gefundenen Näherungslösungen waren vielfach von ungenügender Genauigkeit.

Ein Verfahren zum Entwurf zweidimensionaler FIR-Filter durch aufeinanderfolgende Projektionen ist dem Dokument IEEE Transactions on Circuits and Systems, Bd. 31, Nr. 9, September 1984, New York, US; A. Abo-Taleb et al.: "Design of FIR Two-Dimensional Digital Filters by Successive Projection" zu entnehmen.

Dementsprechend ist es insbesondere die Aufgabe der vorliegenden Erfindung, eine Vorrichtung anzugeben, die es ermöglicht, eine vorgegebene Sollwertfunktionen in einfacher Weise und trotz starker Bandbreiteneinsparung mit ausreichender Genauigkeit durch eine andere Funktion anzunähern.

Der vorliegenden Erfindung liegt darüber hinaus die Aufgabe zugrunde, weitere Einrichtungen und Verfahren im Bereich der Mustererkennung anzugeben, die erst aufgrund oben genannter Vorrichtung ermöglicht werden, die darüberhinaus aber noch weitere erfinderische Besonderheiten aufweisen.

Die erstgenannte Aufgabe wird durch die Gegenstände der unabhängigen Patentansprüche 1, 2, 3, 4 und 5 gelöst.

Der Vorteil des speziellen adaptiven Filters gemäß Patentanspruch 1 liegt in der Fähigkeit dieses Filters, seine einzelnen Elementarfilter so auszurichten, daß mit ihnen eine optimale Beschreibung einer vorgegebenen Sollfunktion F ermöglicht wird. Die durch das Filter aufgefundene approximierte Funktion beschreibt eine vorgegebene Sollfunktion F, in für die weitere Verarbeitung leicht handhabbarer Weise und mit einer drastisch reduzierten Informationsbandbreite.

Weitere erfindungsgemäße adaptive Filter sind Gegenstände der Ansprüche 2-4.

Das adaptive Filter gemäß Patentanspruch 5 wird zwar hinsichtlich der Annäherungsgenauigkeit unter Umständen nicht gleich gute Ergebnisse wie das adaptive Filter gemäß Patentanspruch 1 liefern können, jedoch ist dieses adaptive Filter aufgrund eines geringeren Rechenaufwandes in der Lage, seine Berechnungen mit hoher Geschwindigkeit auszuführen und daher insbesondere für Echtzeitanwendungen geeignet.

Die bevorzugte Ausgestaltung gemäß Patentanspruch 6 des adaptiven Filters nach Patentanspruch 5, bei der eine Vielzahl von Elementarfiltersätzen vorhanden sind, die jeweils einen Unterraum aufspannen, führt zu einer Erhöhung der Annäherungsgenauigkeit, wobei der Vorteil der hohen Berechnungsgeschwindigkeit weiterhin erhalten bleibt.

Die Ausführungsform gemäß Patentanspruch 7 weist den zusätzlichen Vorteil auf, daß die Feststellung, welche der Projektionen auf die einzelnen Unterräume bei der Ausführungsform gemäß Patentanspruch 3 die beste Annäherung an die Sollfunktion ist, in besonders eleganter und zeitsparender Weise ausgeführt werden kann.

Bevorzugtermaßen weisen die erfindungsgemäßen adaptiven Filter Elementarfilter auf, deren Charakteristika durch Gauß-, Gabor-, Sigmoid- oder tanh-Funktionen beschrieben werden können. Derartige Filtertypen sind mathematisch besonders leicht erfaßbar und handhabbar.

In einer weiteren bevorzugten Ausführungsform der erfindungsgemäßen adaptiven Filter sind alle Elementarfilter zueinander linear unabhängig, was den Vorteil eines geringen Rechenaufwandes mit sich bringt.

Die anzunähernde Sollfunktion F wird bevorzugterweise sowohl bezüglich des Wertebereichs als auch bezüglich der Auflösung diskret eingelesen, wodurch die digitale Verarbeitung der Ergebnisse in üblichen Mikroprozessoren ermöglicht wird. Selbstverständlich kommt auch die Verarbeitung einer kontinuierlichen Funktion durch das erfindungsgemäße Filter in Betracht, beispielsweise, wenn die Sollfunktion ein optisches Signal ist.

Für bestimmte Anwendungsfälle kann es vorteilhaft sein, die Parameter der Elementarfilter zumindest nach dem Auffinden der angenäherten Funktion auszugeben, um sie für weitere Verarbeitungsschritte nutzbar zu machen.

Weiterhin sieht eine bevorzugte Ausführungsform vor, daß für den Fall einer unvollständig erfaßten Sollwertfunktion die entsprechenden Lücken durch die in der Umgebung der Lücke vorkommenden Funktionswerte angenähert und mit zusätzlichem additiven Rauschen beaufschlagt werden. Dadurch werden die fehlenden Funktionswerte mit hoher Wahrscheinlichkeit einigermaßen gut angenähert, so daß die Filtereinstellung von den ursprüngliche fehlenden Funktionswerten kaum beeinflußt wird und möglicherweise zu denselben Ergebnissen führt, wie sie bei einer vollständig vorgegebenen Sollwertfunktion zu erwarten wären. Dies wäre nicht der Fall, wenn man für die fehlenden Funktionswerte beispielsweise jeweils den Wert 0 ansetzt.

Das für die Minimierung der Differenz zwischen Projektion und Sollwertfunktion verwendete übliche Berechnungsverfahren ist vorzugsweise ein Gradientenabstiegsverfahren (deterministisches Verfahren), das zu einer schnellen Minimierung der Differenz führt.

In einer weiteren bevorzugten Ausführungsform kann die Sollfunktion F ein optisches Signal sein, also beispielsweise das von einer Fernsehkamera aufzunehmende Bild. Für optische Anwendungen ist das erfindungsgemäße adaptive Filter insbesondere geeignet, da hier große Informationsmengen vorliegen, die für die Übertragung soweit wie möglich reduziert werden müssen. In diesem Zusammenhang ist klar, daß die Sollfunktion auch ein elektrisches Video- bzw. Audio-Signal sein kann.

Für den Fall von Video-Signalen und optischen Signalen können die Elementarfilter optische Filter sein. Schließlich ist bei einer bevorzugten Ausführungsform das adaptive Filter so ausgelegt, daß es als approximierte Funktion ein bandbreitereduziertes HDTV-Signal ausgibt.

Weitere vorteilhafte Ausgestaltungen ergeben sich aus den übrigen Unteransprüchen.

Im folgenden wird die Erfindung anhand von Beispielen unter Bezugnahme auf die beiliegenden Zeichnungen näher erläutert. Dabei zeigen im einzelnen:

| | |
|---|---|
| Fig.1 | ein Blockschaltbild des erfindungsgemäßen Filters, |
| Fig.2 und 3 | Vektordiagramme zur Erläuterung des der Erfindung zugrundeliegenden mathematischen Prinzips, |
| Fig.4 | ein Beispiel für verwendbare Elementarfilter, |
| Fig.5, 5a bis 12 | die stufenweise Annäherung einer Nicht(XOR)Funktion durch eine von dem erfindungsgemäßen Filter entwickelte Funktion, |
| Fig.13 | ein Flußdiagramm der von dem Filter angewandten Rechenoperation, |
| Fig.14 | ein allgemeines Beispiel, wie eine Sollfunktion hoher Bandbreite durch eine informationsreduzierte Annäherungsfunktion beschrieben werden kann, |
| Fig.15 | ein weiteres Flußdiagramm einer von dem Filter anwendbaren Rechenoperation. |

Bekanntermaßen kann ein gegebener Vektor unter Voraussetzung einer orthogonalen Koordinatensystems durch die gerichtete Addition seiner Projektionen auf die einzelnen Achsen des Raumes ausgedrückt werden. Sobald jedoch die den Raum aufspannenden Achsen nicht mehr senkrecht aufeinander stehen, gilt dieser Zusammenhang nicht mehr, wie anhand von Figur 2 ersichtlich ist.

Das zueinander nicht orthogonale Achsenpaar $g_0$, $g_1$ spannt einen zweidimensionalen Raum auf, in dem der Vektor A liegt. Addiert man die gerichteten Projektionen $A_0$, $A_1$ des Vektors A auf die Achsen $g_0$, $g_1$, so resultiert dies in einem anderen Vektor als dem Ausgangsvektor A. Um wieder den Vektor A zu erhalten, ist eine Multiplikation der einzelnen Projektionen mit dem sogenannten kontravarianten Metriktensor notwendig, der durch Invertierung aus dem kovarienten Metriktensor der Basisvektoren $g_0$, $g_1$ gebildet werden kann.

Die Multiplikation der Basisvektoren $g_0$, $g_1$ mit dem kontravarianten Metriktensor (im folgenden durch das Symbol $g^{ab}$ gekennzeichnet) führt zu einer Skalierung der ursprünglichen Projektionen $A_0$, $A_1$, wie dies in der Figur 2 durch die kürzeren Projektionen $A^0$, $A^1$ angedeutet ist. Die gerichtete Addition dieser durch den Metriktensor bewerteten Projektionen führt wiederum zum Ausgangsvektor A.

Mathematisch läßt sich diese Operation wie folgt ausdrücken:

$$A = \sum_a \sum_b A_a g^{ab} g_b \qquad (1)$$

wobei $A_a$ die Projektionen des Vektors A auf die Basisvektoren $g_a$ angibt, die mathematisch durch entsprechende Skalarmultiplikation erhalten werden können.

Figur 3 zeigt wiederum eine Ausgangsfunktion F (Sollwertfunktion) und ein Basisvektorpaar $g_0$, $g_1$. Da der dargestellte Raum dreidimensional ist, spannt die Basis $g_0$, $g_1$ lediglich einen zweidimensionalen Unterraum darin auf. Die Projektion der Sollfunktion (Soll-Vektor) F auf diesem Unterraum ist wiederum durch Vektor A dargestellt. Diese Projektion ergibt sich wie oben durch die gerichtete Addition der mit dem kontravarianten Metriktensor der Basisvektoren bewerteten Projektionen der Sollfunktion F auf die beiden Basisvektoren go, g1. Die beiden bewerteten Projektionen

$A^0$, $A^1$ ergeben, wenn sie gerichtet addiert werden, die Projektion A der Funktion F auf dem durch die Basis go, gl aufgespannten Unterraum.

Auch in diesem Fall läßt sich die Projektion A formelmäßig durch die Formel 1 erfassen, wenn für die Normalprojektionen $A_a$ die Projektion der Sollfunktion F auf die Basisvektoren (ermittelbar mit Hilfe z. B. von Skalarmultiplikationen) verwendet werden.

Die Projektion A weicht um die gestrichelt angedeutete Differenz D von der Ausgangsfunktion F ab. Formelmäßig läßt sich das durch folgenden Zusammenhang erfassen

$$D = F - \sum_a \sum_b A_a g^{ab} g_b \qquad (2)$$

wobei $A_a$ wiederum für die Projektionen der Ausgangsfunktion F auf die Basisvektoren g0, g1 steht.

Es sei darauf hingewiesen, daß Formel 2 nur in euklidischen und nicht gekrümmten Räumen anwendbar ist und für andere Räume durch eine entsprechende Abstandsfunktion ersetzt werden muß. Somit lautet Formel 2 allgemein:

$$D = f\left(F; \sum_a \sum_b A_a g^{ab} g_b\right) \qquad (2')$$

Die durch die Formel 2 ausgedrückte Abweichung der Projektion A von der Funktion F läßt sich, wenn man für die Basisvektoren g0, g1 sich drehende Vektoren zuläßt mit bekannten mathematischen Verfahren, beispielsweise dem Gradientenabstiegsverfahren minimieren. Dies bedeutet bildlich ausgedrückt, daß sich der durch g0, g1 aufgespannte Unterraum und die darin abgebildete Projektion A in Richtung der Ausgangsfunktion F dreht, bis sie schließlich mit dieser zur Deckung kommt. Während des Hochdrehens des Unterraums verändern sich die Darstellungen der Basisvektoren, der aus ihnen zu berechnende kontravariante Metriktensor und die Projektionen der Funktion F auf die einzelnen Basisvektoren (in Fig. 3 sind jedoch bereits die mit dem Metriktensor bewerteten Projektionen $A^0$, $A^1$ eingetragen).

Die oben erläuterte Berechnung der Projektion A mit Hilfe des Metriktensors betrifft jedoch nur eine spezielle Ausführungsform der vorliegenden Erfindung. Im folgenden werden weitere spezielle Ausführungsformen des erfindungsgemäßen adaptiven Filters erläutert, bevor anschließend auf eine allgemeine Beschreibung des erfindungsgemäßen adaptiven Filters eingegangen wird, der auf das Grundprinzip dieser vorgestellten Ausführungsformen abstrahiert ist und somit stellvertretend für alle weiteren Ausführungsformen des adaptiven Filters steht, welche dem Fachmann nach dem Studium der erläuterten Ausführungsformen ohne weiteres erkennbar sein werden.

Zunächst wird für das weitere Verständnis nochmals Bezug auf Fig. 2 genommen. In Fig. 2 ist nicht nur das Basisvektorpaar $g_0$, $g_1$ eingetragen, sondern auch das dazu biorthogonal adjungierte Basenpaar $g^0$, $g^1$. Ersichtlicherweise läßt sich der Vektor A nicht nur durch die gerichtete Addition der bewerteten Projektionen $A^0$ und $A^1$ darstellen, sondern auch durch die zwei weiteren eingezeichneten Vektoren $A_0'$, $A_1'$ entlang der adjungierten Basen $g^0$, $g^1$, deren Normalprojektionen auf das Basenpaar $g_0$, $g_1$ ebenfalls $A_0$ und $A_1$ betragen. Bezogen auf die Berechnung der Projektion A in den aufgespannten Unterraum lassen sich diese beiden grundlegenden Möglichkeiten formelmäßig wie folgt darstellen:

$$A = \sum_a A^a g_a \qquad (3)$$

$$\text{mit } A^a = \sum_b g^{ab} A_b$$

$$A = \sum_a A_a g^a \quad \text{mit} \quad g_b = \sum_a g^{ba} \cdot g_a \tag{4}$$

Vereinfachend ausgedrückt ist es also möglich, die gesuchte Projektion A als Summe der Multiplikationen der kontravarianten Komponenten $A^a$ mit ihren jeweiligen Basisvektoren $g_a$ auszudrucken, wobei die kontravarianten Komponenten in diesem Fall unter Verwendung des Metriktensors $g^{ab}$ errechnet werden oder durch die Summe der Multiplikationen aus den Normalprojektionen $A_a$ mit ihren jeweiligen biorthogonal adjungierten Basen $g^a$, wobei diese biorthogonal adjungierten Basen, in diesem Fall unter Verwendung des Metriktensors $g^{ba}$ berechnet werden.

Diese beiden Fälle werden im folgenden als Hauptfall 1 und Hauptfall 2 bezeichnet. Die Zusammenhänge werden später nochmals im Zusammenhang mit Fig. 13 erläutert, wobei auch die entsprechenden Formeln explizit nochmals in Block 132 der Fig. 13 aufgeführt sind.

Die Heranziehung des kontravarianten Metriktensors zur Berechnung der Projektion A ist für die vorliegende Erfindung nicht zwingend und stellt demgemäß, wie oben erwähnt, nur eine spezielle Ausführungsform der Erfindung dar. Obwohl die Verwendung des Metriktensors zu einer mathematisch eleganten Berechnungsweise der Projektion A führt, haben Berechnungsverfahren für die Projektion A, die ohne den Metriktensor auskommen, den Vorteil, daß hierbei die rechnerisch aufwendige Invertierung des kovarianten Metriktensors zur Berechnung des kontravarianten Metriktensors unterbleiben kann. Da die Invertierung des kovarianten Metriktensors für jede Verdrehung des Achsenpaares $g_0$, $g_1$ erneut berechnet werden muß, führt dies verständlicherweise inbesondere bei Tensoren mit vielen Dimensionen zu einem hohen Rechenaufwand. Als Beispiel für ein Berechnungsverfahren für eine weitere bevorzugte Ausführungsform des erfindungsgemäßen adaptiven Filters wird daher im folgenden ein Verfahren erläutert, welches ohne das Hilfsmittel des kontravarianten Metriktensors auskommt.

Da sich die Projektion des Vektors A auf den Basisvektor $g_a$ wie folgt ausdrücken läßt:

$$A_a = \sum_b g_{ba} A^b \quad , \tag{5}$$

wobei $g_{ba}$ den kovarianten Metriktensor angibt, somit gilt:

$$A_a - \sum_b g_{ba} A^b = 0 . \tag{6}$$

Somit läßt sich durch Minimierung dieser Abstandsfunktion die noch unbekannte bewertete Projektion $A^b$ auffinden. Mathematisch läßt sich das wie folgt ausdrücken:

$$\left(A_a - \sum_b g_{ba} A^b\right) \text{minimal}$$
$$\Rightarrow \left(A_a - \sum_b g_{ba} A^b\right)^2 \text{minimal} . \tag{7}$$

Somit läßt sich für alle a schreiben:

$$\Rightarrow \qquad E = \sum_a \left(A_a - \sum_b g_{ba} A^b(t)\right)^2 \text{ minimal },$$

wobei A (t) nun eine zeitabhängige Größe oder Satz von Größen angibt, die so zu verändern sind, daß E möglichst klein wird.

Dies kann beispielsweise durch ein klassisches Gradientenabstiegsverfahren erreicht werden: sei für alle $\sigma$:

$$\frac{d A^\sigma(t)}{dt} = -\frac{dE}{dA^\sigma} = -\frac{d \sum_a \left(A_a - \sum_b g_{ba} A^b(t)\right)^2}{d A^\sigma}$$

$$= +2 \left( \sum_a \left[ A_a - \sum_b g_{ba} A^b(t) \right) \cdot g_{\sigma a} \right]$$

A (t) ändert sich jetzt solange, bis

$\frac{\partial A^\sigma}{\partial t} = 0$ gilt oder die "Energie" E unter einem

Sollwert liegt. Dies ist der Fall, wenn $A^\sigma$ (t) nahe der gesuchten Größe A ist.

Somit läßt sich die Darstellung der Projektion A auch ohne Verwendung des kontravarianten Metriktensors durch Minimierung der Abstandsfunktion auffinden.

Anhand von Fig. 2 läßt sich das Minimierungsverfahren anschaulich erläutern. Bekannt sind die Normalprojektionen $A_0$, $A_1$ auf das Basenpaar $g_0$, $g_1$. Das Minimierungsverfahren erreicht nun, daß beliebige Vektoren $A^{0'}$, $A^{1'}$ in Richtung der Basisvektoren $g_0$, $g_1$ in ihrer Länge so ausgerichtet werden, bis die Normalprojektionen ihrer gerichteten Addition A' gleich den Projektionen $A_0$, $A_1$ des gesuchten Vektors A auf die Basisvektoren $g_0$, $g_1$ sind. Ein Vektor A', der dieser Bedingung genügt, ist aber gerade der gesuchte Vektor A, so daß damit die Längen der entsprechend veränderten Vektoren $A^{0'}$, $A^{1'}$, deren gerichtete Addition den Vektor A' ausmachen, den gesuchten bewerteten Projektoren $A^0$, $A^1$ entsprechen.

Statt von der obigen Gleichung 5 auszugehen, könnte ein entsprechendes Minimierungsverfahren auch von folgender Gleichung ausgehen:

$$D = \left(F - \sum_b A^b g_b\right)^2 . \qquad (8)$$

Diese Gleichung läßt sich wie oben durch Differenzieren nach $A^i$ wie folgt minimieren:

$$\frac{dA^{\sigma}(t)}{dt} = -\frac{\partial D}{\partial A^{\sigma}} = -2\left(F - \sum_b A^b(t)\, g_b\right) \frac{d\left(-\sum_b A^b(t)\cdot g_b\right)}{dA^{\sigma}}$$

$$= +2\left(F - \sum_b A^b(t)\, g_b\right) g_{\sigma} . \qquad (9)$$

Anschaulich gesprochen besteht der Unterschied zwischen einer Minimierung ausgehend von Formel 5 und einer Minimierung ausgehend von Formel 8 darin, daß bei Formel 8 eine Minimierung des Abstandes zwischen der Sollfunktion F und der gerichteten Addition der bewerteten Komponenten stattfindet, wohingegen bei dem auf Gleichung 5 aufbauenden Verfahren eine Minimierung des Abstandes zwischen den Normalprojektionen der Sollfunktion F auf die Basisvektoren und den entsprechenden Normalprojektionen des Vektors A' auf die Basisvektoren durchgeführt wird.

Als weitere Möglichkeit zur Berechnung der Projektion A wird im folgenden ein iteratives Verfahren vorgestellt.

Die Größe $A^a$ wird iterativ berechnet, wobei die Iteration über den Satz von Beispielen geht.

Die Größen $A^a$ werden berechnet, indem der neue Wert aus dem jeweils davor berechneten Wert abgeleitet wird. Der Vorteil des Verfahrens liegt darin, daß man nicht alle Beispiele speichern muß, sondern nach und nach einlesen kann.

Die Gleichungen lauten:

$$\begin{aligned}
&(1)\quad A^a(t) = A^a(t-1) + g^a(t)\, \varepsilon(t) \\
&(2)\quad g^a(t) = \sum_b g^{ab}(t)\cdot g_b(t) \qquad\qquad (10)\\
&(3)\quad \varepsilon(t) = F(t) - \sum_b A^b(t-1)\, g_b(t-1),
\end{aligned}$$

wobei sich der kontravariante Metriktensor beispielsweise wie folgt berechnen läßt:

$$g^{ab}(t) = g^{ab}(t-1) - \frac{\sum_k \sum_l \left[ g^{ak}(t-1)\, g_{kl}(t)\, g^{lb}(t-1) \right]}{\left[ 1 + \sum_a \sum_b g_a(t)\, g^{ab}(t-1)\, g_b(t) \right]} .$$

Daraus ergibt sich:

$$g^a(t) = \sum_b g^{ab}(t-1)\, g_b(t) \Big/ \left[1 + \sum_a \sum_b g_a(t)\, g^{ab}(t-1)\, g_b(t)\right].$$

Die beiden zuletzt erläuterten Berechnungsverfahren sowie das anfänglich vorgestellte Berechnungsverfahren unter Verwendung des Metriktensors sind entsprechend der oben getroffen Fallunterscheidung sämtlich dem Hauptfall 1 zuzuordnen, d.h. bei diesem Verfahren werden auf unterschiedlichen Wegen die bewerteten Komponenten $A^a$ berechnet.

Im folgenden werden entsprechende Verfahren zum Hauptfall 2 erläutert, d.h. in den folgenden Verfahren besteht die Berechnung der jeweils adjungierten Basen im Vordergrund.

Ein dieser Gruppe zurechenbares Verfahren besteht darin, die adjungierten Basen mittels des kontravarianten Metriktensors zu berechnen. Formelmäßig ausgedrückt bedeutet dies:

$$g^b = \sum_a g^{ba} \cdot g_a \quad , \qquad (11)$$

wobei sich die gesuchte Projektion A auf dieser Formel aufbauend wie folgt ausdrücken läßt:

$$\vec{A} = \sum_a A_a\, g^a \quad . \qquad (12)$$

Dieses Verfahren korrespondiert somit zu dem zur ersten Fallgruppe gehörigen anfänglich vorgestellten Verfahren, bei dem die bewerteten Komponenten mittels des kontravarianten Metriktensors berechnet werden. Wie bereits oben erwähnt, sind diese zwei korrespondierenden Verfahren nochmals explizit im Block 132 der Fig. 13 aufgeführt.

Ein weiteres Verfahren dieser Fallgruppe, welches ohne den kontravarianten Metriktensor auskommt und somit ohne eine bei jedem Schritt durchzuführende Invertierung des kovarianten Metriktensors auskommt, ist das folgende:

Ausgehend von dem Zusammenhang

$$g_a = \sum_b g_{ab}\, g^b \qquad (13)$$

führt man zur Berechnung der unbekannten adjungierten Basisvektor $g^a$ folgende Minimierung aus:

$$g_a - \sum_b g_{ab}\, g^b(t) \to \text{minimal} \quad . \qquad (14)$$

Dafür läßt sich äquivalent für alle a schreiben:

$$E = \sum_a \left( g_a - \sum_b g_{ab}\, g^b(t) \right)^2 \text{ minimal}, \qquad (15)$$

wobei $g^b(t)$ nun eine zeitabhängige Größe ist, die es so zu verändern gilt, daß obiges E möglichst klein wird. $g^b(t)$ wird nun so verändert, daß E minimiert wird, was beispielsweise wiederum durch ein klassisches Gradientenabstiegsverfahren erreichbar ist:

$$\frac{d\, g^c(t)}{dt} = -\frac{dE}{dg^c} = -\frac{d\left[ \sum_a \left( g_a - \sum_b g_{ab}\, g^b(t) \right)^2 \right]}{d\, g^c} \qquad (16)$$

$$= +2 \sum_a \left( g_a - \sum_b g_{ab}\, g^b(t) \right) g_{ac} \; .$$

$g^a(t)$ ändert sich nun solange, bis dg/dt = 0 oder unter einem Schwellenwert liegt bzw. die Energie kleiner als ein Sollwert ist; ist dies der Fall, so ist die resultierende Größe $g^a(t)$ nahe der gesuchten Größe $g^a$, weil dann der Fehler E minimal ist.

Dieses Verfahren korrespondiert somit mit dem zweiten, zur Fallgruppe 1 vorgestellten Verfahren.

Eine weitere, für das obige Verfahren heranzuziehende Fehlerfunktion wäre die folgende:

$$D = \left( F - \sum_a A_a\, g^a(t) \right)^2 . \qquad (17)$$

Diese läßt sich wie oben nach $g^a$ minimieren:

$$\frac{d\, g^c(t)}{dt} = -\frac{\partial D}{\partial g^c} = -2 \left( F - \sum_a A_a\, g^a(t) \right) \cdot \frac{d\left( -\sum_a A_a\, g^a(t) \right)}{d g^c}$$

$$= +2 \left( F - \sum_a A_a\, g^a(t) \right) A_c \; . \qquad (18)$$

Eine weitere Möglichkeit, durch Gradientenabstieg die kontravariante Basis zu berechnen, besteht durch Verwen-

dung folgender Grundgleichung:

$$g(t+1)^a = g(t)^a + \gamma \left( g(t)_a + \sum_b g_{ab} \cdot g(t)^b \right). \qquad (19)$$

Als dritte Möglichkeit bietet sich ein iteratives Verfahren an, wie es oben für den ersten Hauptfall beschrieben wurde.

Im folgenden wird nun, wie oben bereits angedeutet, das allen Berechnungsverfahren zugrundeliegende Prinzip erläutert:

Die Projektion der Sollfunktion F auf dem von den Vektoren $g_a$, $g_b$ aufgespannten Unterraum entspricht der Lösung eines klassischen Problems der linearen Algebra des sog. "Least Squares"-Problems. Alle oben vorgestellten Lösungsansätze sind spezielle Lösungen der folgenden allgemeinen Gleichung:

$$MX = B. \qquad (20)$$

Dabei ist M eine bekannte Matrix, X ein zu suchender Vektor, und B ein bekannter Vektor.

Die Dimension des Vektors X sei kleiner als die Dimension von B und die Matrix M ist entsprechend von der Dimension X mal der Dimension von B.

Das dadurch gebildete Gleichungssystem hat im Regelfall keine exakte Lösung, da die Anzahl der Gleichungen größer ist als die Anzahl der Unbekannten, das System somit überbestimmt ist. Allerdings sind auch Fälle denkbar, bei denen die Dimension von X größer oder gleich der Dimension von B sind. Auch diese sind durch nachfolgendes Verfahren lösbar. Mit Hilfe eines Verfahrens, daß allgemein als "Least Squares"Verfahren in der Mathematik bekannt ist, läßt sich jedoch auf der Grundlage des kleinsten mathematischen Fehlers eine Lösung finden. Bezogen auf die vorliegende Erfindung entspricht B der Sollfunktion F, M einer Matrix, die aus den kovarianten Basisfunktionen $g_a$ dadurch gebildet wird, daß man die Basisfunktionen kolonnenweise nebeneinander schreibt und X entspricht dem Vektor der gesuchten kontravarianten bzw. bewerteten Komponenten $A^a$. Das Matrix-Vektor-Produkt MX läßt sich somit wie folgt ausdrücken:

$$MX = \sum_a g_a A^a. \qquad (21)$$

Dies entspricht der Projektion A auf den Unterraum. Die Projektion A ist somit die "Least Squares"-Lösung des Gleichungssystems.

Aufgrund dieses aufgezeigten allgemeinen Zusammenhangs sei somit nochmals ausdrücklich darauf hingewiesen, daß die vorliegende Erfindung nicht auf die Verwendung der oben explizit erwähnten Berechnungsverfahren beschränkt ist, sondern daß die vorliegende Erfindung jegliche Lösungsansätze mit einschließt, die sich mit der Lösung des gemäß der Gleichungen 20 und 21 ausgedrückten Grundproblems befassen. Erläuternd sei darauf hingewiesen, daß sich das zuerst beschriebene Verfahren, welches für die Berechnung den Metriktensor heranzieht, hier als Lösung der sog. Normalgleichungen auf direktem Weg darstellt. Formelmäßig läßt sich dies wie folgt ausdrücken:

$$M^T M X = M^T B$$

$$\rightarrow X = (M^T M)^{-1} M^T B. \qquad (22)$$

Denkbare andere Lösungsansätze, die oben nicht explizit vorgestellt wurden, die aber auch als Lösung des allgemeinen Problems angesehen werden können, sind beispielsweise das sog. "Singular Value Decomposition"-Verfahren, was ein weiteres Verfahren zur Matrix-Inversion darstellt.

Zum leichteren Verständnis der obigen Zusammenhänge seien diese nochmals anhand der Fig. 3 graphisch erläutert.

Der Grundgedanke besteht darin, daß die Projektion A der Sollfunktion F in den aufgespannten Unterraum sich auf der Grundlage der Erkenntnis berechnen läßt, daß die momentan berechnete Projektion A' nur dann der tatsächlichen Projektion A der Sollfunktion F auf den Unterraum entspricht, wenn diese momentan berechnete Projektion A' die gleichen Projektionen auf den aufgespannten Unterraum aufweist wie die Sollfunktion F. Mit anderen Worten weist die Sollfunktion F, obwohl sie nicht in dem aufgespannten Unterraum liegt, die gleichen Projektionen auf die Basisvektoren auf wie ihre tatsächliche, im Unterraum liegende Projektion A. Alle oben vorgestellten Verfahren nach Hauptfall 1 machen sich diesen Zusammenhang zunutze, um das eigentlich nicht lösbare Gleichungssytem

$$\sum_a g_a A'^a = F \qquad (23)$$

dennoch lösen zu können. Die Skalarmultiplikation der Sollfunktion F auf das betrachtete Basenpaar entspricht nur dann der Projektion des linken Terms auf das betrachtete Basenpaar, wenn der linke Term der gesuchten Projektion A entspricht.

Insbesondere bei Verfahren, die ohne Verwendung des kontravarianten Metriktensors auskommen, bei denen daher entsprechend der Fallgruppe 1 und 2 bereits die Größen $A^a$ bzw. $g^a$ durch Minimierungsverfahren, wie etwa dem Gradientenabstiegsverfahren, berechnet werden müssen, bietet sich an, in dem erfindungsgemäßen Filter zwei voneinander unabhängige Berechnungsmodule vorzusehen, die dann ihre berechneten Werte untereinander austauschen.

Beispielsweise wäre eine erste Untereinheit 1 für die Berechnung der Größen $g^a$ bzw. $A^a$ zuständig. Eine weitere Untereinheit 2 wäre dann für die Berechnung der Abweichung der Approximation der Sollfunktion von der Sollfunktion selbst zuständig. Dem Filter würden somit für die Initialisierung anfänglich Zufallswerte für die Parameter der Filter $g_a$ eingegeben werden. Daraus würde der Filter dann $g_a$ und $A_a$ berechnen.

Mit diesen Werten würde die Untereinheit 1 die Werte für $A^a$ bzw. $g^a$ iterativ oder auf anderem Wege berechnen.

Sobald die entsprechenden Werte berechnet sind, führt die Untereinheit 2 einen oder wenige Schritte zur Minimierung der Abweichung durch. Daraus resultieren wiederum neue Werte für $g_a$ und $A_a$.

Aufbauend auf diesen Werten berechnet Untereinheit 1 dann wiederum neue Werte für $A^a$ bwz. $g^a$, die wiederum Grundlage für einen oder wenige Schritte der Untereinheit 2 sind.

Dies wird iterativ solange fortgesetzt, bis die Untereinheit 2 ihrerseits voll konvergiert hat und somit die Approximation an die Sollfunktion optimal gelöst ist.

Untereinheit 2 würde also immer nur einen oder wenige Schritte durchführen, während Untereinheit 1 stets vollständig konvergiert.

Das Verfahren kann natürlich auch mit Hilfe gekoppelter Differentialgleichungen durchgeführt werden, wobei dann die Zeitkonstanten der Untereinheit 2 entsprechend höher liegen würden als die der Untereinheit 1, damit letztere schneller rechnen kann.

Verläßt man nun den anschaulichen, in Fig. 3 gezeigten Vektorraum und spannt den Unterraum im Funktionenraum durch ein Paar zueinander verschobener Gaußfilter, wie sie in Fig. 4 gezeigt sind, auf, so läßt sich das oben angesprochene Drehen der den Unterraum aufspannenden Basis leichter verstehen.

Die in Fig. 4 gezeigten Gaußkurven 1, 2 können als Filterfunktionen über die Zeit oder den Ort aufgefaßt werden. Statt der Gaußkurven kommt jeder andere Kurvenverlauf in Frage, insbesondere auch sogenannte Gaborfunktionen. Auch können die in Fig. 4 gezeigten Filter 1, 2 mehrdimensional sein, also beispielsweise zwei "Hügel" über einem zweidimensionalen Feld.

Auch durch die Filter 1, 2 kann im Funktionenraum ein Unterraum aufgespannt werden, da die Filter aufgrund der Verschiebung zueinander linear unabhängig sind. Werden diese Filter diskret angenommen, so können sie durch einen in seiner Dimension mit der Auflösung übereinstimmenden Vektor dargestellt werden. Geht die Auflösung gegen Unendlich, so kann der entsprechende Vektor eine unendliche Dimension annehmen, was einer analogen Filterfunktion entspricht.

Weitere bevorzugte, im Rahmen der folgenden Erfindung zu verwendende Elementarfunktionen werden weiter unten behandelt.

Stellt nun eine anzunähernde Sollfunktion F beispielsweise ein "Gebirge" über einer Ebene dar, so ist das erfindungsgemäße adaptive Filter durch Verwendung zweidimensionaler Gaußfilter in der Lage, das Gebirge nachzubilden.

Dies geschieht, indem die Gaußfilter an die Orte der Erhebungen des Gebirges geschoben werden und dort entsprechend dem Gebirgsverlauf durch Parameterveränderung (z. B. Standardabweichung) spitzer oder stumpfer gemacht und entsprechend gestreckt werden. Ein derartiger Gebirgsverlauf kann beispielsweise durch tausend Elementar-Gaußfilter, die entsprechend verschoben und geformt werden, nachgebildet werden. Für eine einfache Gebirgsform können auch bereits einige wenige Elementarfilter, unter Umständen sogar ein einziger, ausreichen, um das Wesen der Ausgangsfunktion in einer der Weiterverarbeitung genügenden Weise nachzubilden. Ist das Gebirge einmal durch die eingestellten Elementarfilter beschrieben, so ist der Informationsgehalt der ursprünglichen Funktion drastisch bis auf einige wenige Filterparameter reduziert.

Bei diesem Beispiel entspricht das Verschieben und Formen der zweidimensionalen Gaußfilter dem im Zusammenhang mit Fig. 3 bezeichneten Drehen des Untervektorraums in Richtung der Ausgangsfunktion F. Bei dem in Formel 2 angegebenen Zusammenhang repräsentiert $g_a$ die zweidimensionalen gaußförmigen Elementarfilter. Sowohl die Projektionen der Ausgangsfunktion F (Gebirge!) auf die Elementarfilter $A_a$, als auch die Elementarfilter selbst und der aus ihnen gebildete kontravariante Metriktensor sind von den die Elementarfilter beschreibenden Parametern abhängig und ändern sich mit einer Verschiebung, Drehung oder Formänderung der Elementarfilter ständig mit. Die Differenz D kann, wie oben bereits erwähnt wurde, mittels herkömmlicher Berechnungsmethoden, die deterministische Natur (Gradientenabstiegsverfahren) oder auch stochastischer Natur ("simulated annealing", "Monte Carlo") sein können, minimiert werden, so daß sich nach erfolgter Minimierung die optimale Annäherung der Ausgangsfunktion über eine Beschreibung durch die eingestellten Elementarfilter ergibt.

Diese Minimierung läuft selbständig ab, so daß der erfindungsgemäße adaptive Filter selbständig in die beste Annäherung konvergiert.

Dem erfindungsgemäßen adaptiven Filter wird also eine Sollfunktion eingegeben, die er dann aufgrund seiner Filterstruktur automatisch durch eine mit Elementarfiltern beschreibbare Funktion optimal annähert und ausgeben kann. Die angenäherte Funktion ist, wie erwähnt, in hohem Maße in der Bandbreite reduziert, wodurch sich vielfältige Anwendungsmöglichkeiten ergeben, auf die im folgenden noch näher eingegangen wird.

Eine Ausführungsform des erfindungsgemäßen Filters ist in Fig. 1 schematisch dargestellt. Der Filter 1 liest in seinen Speicher 2 eine nachzubildende Funktion F ein. Weiter weist der Filter 1 einen Speicher 3 auf, in dem zumindest ein Satz von Elementarfiltern abgelegt ist, die für die Annäherung verwendet werden. Dadurch ist eine CPU 4 in der Lage, die Normalprojektionen der Funktion F auf die Elementarfilter zu berechnen (Skalarmultiplikation), und die Berechnung des kontravarianten Metriktensors von den Elementarfiltern durchzuführen, so daß jeweils die Differenz D gemäß Formel 2 in Abhängigkeit der Filterparameter (Mittelwert, Standardabweichung, etc.) darstellbar ist, welche dann mittels eines programmierten Minimierungsalgorithmus minimiert werden kann. Nach erfolgter Minimierung gibt das adaptive Filter die angenäherte, informationsreduzierte Funktion $F_{app}$ aus, die für die weitere Verarbeitung verwendet wird. Die approximierte Funktion entspricht in der Formel 2 dem Substrahenten nach erfolgter Minimierung.

Das Filter 1 hat damit eine übliche Filterungsfunktion selbständig bewerkstelligen können, nämlich gewünschte wesentliche Komponenten aus einem Eingangssignal zu extrahieren. In einem weiteren Speicher 5 kann das Filter 1 die aufgefundene Approximation abspeichern, wobei die abgespeicherten Funktionswerte in Antwort auf eine weiteres Eingangssignal (beispielsweise Ortskoordinaten X, Y) werteweise ausgegeben werden können.

Selbstverständlich kann das Filter 1 auch eine Vielzahl von Sollfunktionen F annähern und im Speicher 5 abspeichern. Dadurch wird es dem adaptiven Filter möglich, eine neu hinzukommende Sollfunktion nach deren Approximation mit bereits gespeicherten Approximationsfunktionen zu vergleichen (was wiederum mit üblichen mathematischen Verfahren möglich ist), um dann aus den abgespeicherten approximierten Funktionen diejenige herauszusuchen, die am besten mit der neu hinzugekommenen und approximierten Funktion korreliert. Auf diese Weise ist eine Mustererkennung möglich. Gegenüber bisherigen Mustererkennungsverfahren weist eine Mustererkennung unter Verwendung des erfindungsgemäßen adaptiven Filters den Vorteil auf, daß sie wesentlich schneller durchführbar ist und dabei geringe Anforderungen an die zu klassifzierende Funktionen gestellt werden müssen, was im folgenden noch näher erläutert wird.

Vorzugsweise stellt die CPU 4 die aufgefundenen Filterparameter an einem eigenen Ausgang zur Verfügung, da diese Parameter die wesentlichen Klassifikationsmerkmale einer approximierten Funktion darstellen.

Die Figuren 5, 5a - 12 zeigen eine Computersimulation der Berechnung einer Annäherungsfunktion durch das adaptive Filter an die in Fig. 5 gezeigte NICHT(XOR)-Funktion, die, wie in Fig. 5a gezeigt ist, zusätzlich mit addaptiven Rauschen beaufschlagt wurde. Nach einer Anzahl von Berechnungsschritten, die in den Figuren 6 bis 11 gezeigt sind, findet das Filter automatisch die in Figur 12 gezeigte Näherungsfunktion.

Obwohl in Fig. 3 die Drehung des Unterraumes nur hinsichtlich einer Dimension erfolgte, ist klar, daß die Elementarfilter eine Drehung in beliebig viele Dimensionen automatisch ausführen können, wobei dann selbstverständlich die Berechnungsmethoden der Minimierung umfangreicher, jedoch nicht unlösbar werden.

Die Minimierung der durch Formel 2 ausgedrückten Differenz D zwischen Sollfunktion und momentan angenäherter Funktion, ausgedrückt durch die veränderbaren Filterparameter, die in dem oben erwähnten Beispiel zu einer Ausrichtung der Filter entsprechend der "Gebirgs"-Form führte und beispielsweise mit Hilfe des Gradientenaufstiegsverfahrens gelöst werden kann, läßt sich anschaulich so auffassen, als ob Kräfte auf die Filter wirken, die diese in die entsprechende Position und Formgebung zwingen. Das System ist also stets bestrebt, den Punkt der geringsten Energie zu erreichen, der einer optimalen Filterausrichtung entspricht.

Die Fig. 13 gibt nochmals die wichtigsten der oben beschriebenen Zusammenhänge in Form eines Flußdiagrammes wieder.

Bei 130 wird dem adaptiven Filter ein Eingangsraum bzw. eine zu approximierende Funktion F eingegeben. Diese Funktion wird durch die im Block 131 vorhandene Filterbank, bestehend aus Elementarfilterfunktionen wie beispielsweise Gaborfiltern, Wavelets", "Splines", Gaußfiltern oder Polynomen, die jeweils parametrisch oder nicht-parametrisch, ortogonal oder nicht orthogonal sein können, auf die entsprechenden Elementarfilter projiziert. Die dadurch enthaltenen Normalprojektionen $A_g$ werden an den Block 132 weitergegeben. Ebenso werden die Elementarfilterfunktionen an diesen Block weitergegeben.

Im Block 132 wird die kontravarianten Komponenten entsprechend der angegebenen Formel berechnet. Dazu wird der kontravariante Metriktensor dem Block 132 zugeführt, der seinerseits aus dem kovarianten Metriktensor mit Hilfe üblicher Berechnungsverfahren, beispielsweise dem Gradientenabstiegsverfahren oder dem Jakobiverfahren, berechnet wurde.

Die Multiplikation der kontravarianten Komponenten mit ihrem entsprechenden Elementarfilter (Basisvektor) führt zu den "gerichteten" kontravarianten Komponenten, die zusammen die Projektion A gemäß einer der beiden Formeln der letzten Zeile des Blocks 132 ergeben. Diese Darstellung der Projektion der Sollfunktion auf den aufgespannten Unterraum wird an den Block 134 weitergegeben, bei dem die Differenz der Projektion gegenüber der Sollfunktion mittels eines Energieminimierungsverfahren verkleinert wird. Die dadurch bewirkte Verdrehung der Elementarfilter wird an den Block 131 weitergeleitet, wo erneut die Normalprojektionen der Funktion F in den gedrehten Unterraum berechnet werden und auch die darauffolgenden Schritte erneut ausgeführt werden. Nach einer bestimmten Anzahl von Berechnungen ist eine energetische Minimierung erreicht und die letztlich aufgefundene Projektion A entspricht der approximierten Funktion und kann vom adaptiven Filter ausgegeben werden.

Eine spezielle Ausführungsform der vorliegenden Erfindung sieht vor, daß bereits die erste Projektion auf den Unterraum als die approximierte Funktion angenommen wird, wodurch sich die Berechnung selbstverständlich wesentlich verkürzt. Ein derartiges Filter kann unter Umständen in sehr kurzen Berechnungszeiten ausreichend gute Ergebnisse liefern. Genauer wird ein derartiges Filter, wenn nicht nur ein Satz Elementarfilter, aufspannend einen ersten Unterraum, verwendet wird, sondern weitere Sätze verwendet werden, die weitere Unterräume aufspannen. In diesem Fall können die Projektionen der Sollfunktionen auf jeden der aufgespannten Unterräume berechnet werden und anschließend diejenige Projektion als approximierte Funktion verwendet werden, deren Differenz zur Ausgangsfunktion F minimal ist. Für die Berechnung der Differenz wird dabei vorzugsweise wiederum der Zusammenhang gemäß Formel 2 (bzw. 2') verwendet. Auch ein derartiges Filter ist selbstverständlich äußerst schnell und insbesondere für Echtzeitanwendung geeignet.

In Fig. 15 sind nochmals die wichtigsten Zusammenhänge für eine bevorzugte Filterstruktur unter Verzicht auf die Berechnung des kontravarianten Metriktensors aufgezeigt, wobei diese Figur anhand der Beschriftungen sowie der obigen Erläuterungen verständlich sein sollte.

Weitere in Zusammenhang mit der vorliegenden Erfindung zu verwendende wichtige Elementarfunktionen sind die folgenden:

$$(24) \qquad g_a\left(X_i,\ i \in \{1, \dots N\}\right. = \mathrm{sigmoid}\left(\sum_i W_{ia} X_i + \theta\right)$$

wobei $W_{ia,\theta}$ Shalare sind, namlich entsprechend die Parameter der Basisfunktion $g_a$ und Sigmoid(a) = $\frac{1}{1+e^{-a}}$.

Diese Funktion wird in ca. 70 % aller neuronalen Netzwerk-Anwendungen verwendet und stellt somit die für einen großen Anwendungsbereich zu wählende Funktion dar.

Eine weitere Funktion wäre die folgende:

$$(25) \qquad g_a\left(X_i,\ i \in \{1, \dots N\}\right) = \tanh\left(W_{ia} X_i + \theta\right)$$

mit

$$\tanh(a) = \frac{e^{+a} - e^{-a}}{e^{+a} + e^{-a}}$$

und $W_{ia}$,$\theta$ wie oben.

Nochmals sei explizit darauf hingewiesen, daß neben den euklidischen Distanzen ausdrücklich auch andere Distanzen in Frage kommen, wie beispielsweise die Kullback-Leibler Entropie, Manhattan-Distanz, Mahalanobis-Distanz etc.

Des weiteren sei darauf hingewiesen, daß es stets genügt, nur den Raum zu betrachten, in dem die Beispiele für die Sollfunktion liegen. Mit anderen Worten genügt es, die zu approximierende Funktion als ein Vektor im Funktionsraum zu betrachten, wobei jedoch nur der Vektor betrachtet wird, der im Beispielsraum liegt.

Ferner reicht es auch stets aus, die Sollfunktion F und das Verfahren nur für die Eingangswerte zu betrachten, für die auch Ausgangsbeispiele vorliegen, d.h. mit anderen Worten, daß eine Berechnung nur in so vielen Dimensionen erfolgt, wie es der Abtastung der Eingangsfunktion entspricht.

In manchen Fällen kann es sinnvoll sein, die rekonstruierte Projektion A nochmals durch eine Funktion h zu verändern, um schwierige Soll-Funktionen auch approximieren zu können. In diesem Fall ist dann die zu minimierende Distanz D:

$$D = \left(F - h \sum_a A^a g_a\right)^2 = F - h\left(\sum_a A_a g^a\right)\Big)^2 . \qquad (26)$$

Weiter sei angemerkt, daß, falls keine analytische Abhängigkeit der Basisfunktion von den Parametern gegeben ist, wie es zum Beispiel bei der fraktalen Funktion der Fall sein kann, auch eine andere Art der Feststellung der Abhängigkeit zum Beispiel durch Minimierung einer Kosten/Fehlerfunktion oder Abschätzung/Heuristik möglich ist.

Ferner kann man eine sigmoide, tanh oder eine andere Funktion auch auf die Projektion $A = \Sigma\, aA_{ag}{}^{a}$ verwenden, so daß dann die zu vermindernde Distanz lautet:

$$D = \left(F - h\left(\sum_a A^a g_a\right)\right)^2 , \qquad (27)$$

wobei h (f) eine Funktion wie sigmoide, tanh oder eine andere repräsentiert.

Allgemein läßt sich das wie folgt schreiben:

$$D = f\left(F, h\left(\sum_a A_a g^a\right)\right) \qquad (28)$$

$$= f\left(F, h\left(\sum_a A^a g_a\right)\right).$$

Ferner sei darauf hingewiesen, daß auch eine andere Kosten/ Fehlerfunktion E einsetzbar ist, dessen Minimierung der Minimierung der Distanz D entspricht.

Als erfindungswesentlich sind auch die folgenden Zusammenhänge zu betrachten:

Sei proj $g^a$ die Projektion der Basisfunktion $g^a$ auf die Ebene, die von der Sollfunktion F und der entsprechenden Basisfunktion $g_a$ aufgespannt wird. Dann ist die Minimierung der Distanz:

$$D = \left(F - \sum_a A_a g^a\right)^2 \qquad (29)$$

der Minimierung der Distanz E

$$E = \sum_a \left(\mathrm{proj}\; g^a - g^a\right)^2$$

äquivalent.

Identisches gilt natürlich im Fall der allgemeinen Distanz:

$$E = \sum_a f\left(\mathrm{proj}\; g^a, g^a\right) \qquad (30)$$

bzw.:

$$b = f\,(F, A^a\, g_a).$$

Schließlich sei noch darauf hingewiesen, daß das erfindungsgemäße Filter auch hierarchisch aus Unterfiltern aufgebaut sein kann. Jeder Unterfilter entspricht dann einer Basisfunktion des höheren Filters. Mehrere Unterfilter spannen somit wiederum den Unterraum auf.

Im folgenden sollen nun einige Anwendungsmöglichkeiten des erfindungsgemäßen adaptiven Filters diskutiert werden, wobei ausdrücklich festgestellt wird, daß zumindest einige der Anwendungsmöglichkeiten weitere über den adaptiven Filter hinausgehende erfinderische Besonderheiten aufweisen, die ebenfalls als erfindungswesentlich anzusehen sind.

Das Prinzip einer der Hauptanwendungsmöglichkeiten des erfindungsgemäßen adaptiven Filters liegt wie oben angesprochen in der Informationsreduktion. Komplizierte Signale können durch eine vom Filter bereitgestellte approximierte Funktion durch wenige Skalare und Filterparameter in ausreichender Weise dargestellt, weiterverarbeitet und abgespeichert werden.

Ein weiterer wesentlicher Aspekt für die Anwendung des erfindungsgemäßen adaptiven Filters besteht in der Möglichkeit, unvollständige Sollfunktionen F durch eine approximierte Funktion anzunähern, wobei diese Approximation aufgrund der Informationsreduktion zu dem gleichen Ergebnis führen kann, das bei einer Approximation an eine vollständig vorgegebenen Sollfunktion aufgetreten wäre. Der Bezug zur Mustererkennung ist offensichtlich.

Wird das adaptive Filter in einem Gerät zur Texturklassifikation eingesetzt, so werden dem Filter unbekannte Texturen eingegeben, die das Filter mittels der oben beschriebenen Zusammenhänge in Form approximierter Funktionen "lernt". Wird nun eine unbekannte Textur eingegeben, so wird diejenige gespeicherte Textur den größten Ausgangswert liefern, die der unbekannten Textur am ähnlichsten ist, wodurch die unbekannte Textur dieser Klasse zugeordnet werden kann.

Neben der Möglichkeit, ein Fernsehbild mittels des erfindungsgemäßen adaptiven Filters in seiner Bandbreite wesentlich reduzieren zu können, ist das erfindungsgemäße Filter auch zur Herausfilterung des Bewegungsvektors, beispielsweise bei HDTV, geeignet. Dazu kann ein sich bewegender Gegenstand in mehreren, zeitlich aufeinanderfolgenden Ebenen in Form eines dreidimensionalen Raumes, bei dem eine Dimension die Zeit ist, aufgefaßt bzw. gespeichert werden. In diesem Raum würde ein sich bewegender Ball einen seiner Bewegung entsprechen Schlauch beschreiben, der einer Sollfunktion F entspricht. Der adaptive Filter wird seine Elementarfilter (mindestens einen) nach diesem Schlauch ausrichten, wodurch die Geschwindigkeit der Bewegung des Balles anhand der Filterneigung bestimmbar ist. Allgemein ausgedrückt, kann das adaptive Filter verwendet werden, um den optischen Fluß in jeder Zeitebene erfassen zu können.

Eine weitere Anwendung ergibt sich in einem Gerät für Stereobildverarbeitung: Der Filter erfaßt jedes der beiden Stereobilder durch Berechnen einer approximierten Funktion und kann aufgrund der unterschiedlichen Ausrichtung der Elementarfilter für jedes einzelne Bild auf das dreidimensionale Bild zurückschließen.

Wird das erfindungsgemäße Filter bei einem Gerät zur Mustererkennung bzw. einem Verfahren zur Mustererkennung bzw. zur Musterklassifizierung eingesetzt, so ergibt sich dabei der Vorteil, daß die Textur, z. B. die Aufnahme eine Gruppe von Personen, lageunabhängig erkannt werden kann. Es ist also nicht notwendig, die Gruppe von Personen auf demselben Winkel zu "fotografieren", wie er bei den Aufnahmen vorlag, die für den vorausgegangenen Schritt des Lernens der einzelnen Texturen (Personen) verwendet wurde. Der erfindungsgemäße Filter ist durch Ausrichten seiner Elementarfilter in der Lage, die unterschiedliche Orientierung im Raum auszugleichen und trotz unterschiedlicher Blickwinkel eine gleiche approximierte Funktion auszugeben. Dadurch wird eine eindeutige Zuordnung der zu klassifizierenden Person zu einer Person innerhalb einer Gruppe vorher "gelernter" Personen ermöglicht.

Auch in der Regelungstechnik bestehen vielfältige Anwendungsmöglichkeiten für das erfindungsgemäße adaptive Filter: Ein über Sensoren detektiertes Regelverhalten bzw. ein vorgegebenes gewünschtes Regelverhalten kann durch das Filter nachgebildet werden, wodurch das gewünschte bzw. detektierte Regelverhalten, da es nunmehr mathematisch exakt erfaßt ist, elektrisch einfach realisiert werden kann, bzw. das Filter kann selbst als Steuereinheit dienen, die nach Eingabe von Eingangswerten (XY in Fig. 1) aufgrund eines gespeicherten Regelverhaltens (Speicher 5 in Fig. 1) den richtigen Ausgangswert liefert.

Wird das erfindungsgemäße adaptive Filter im Zusammenhang mit einem Überwachungssystem oder Überwachungsverfahren verwendet, so ergibt sich der Vorteil, daß es möglich ist, ein durch mehrere Sensoren überwachtes Gebiet auch dann noch überwachen zu können, wenn eine der Sensoren (Kamera) ausfällt. Das erfindungsgemäße Filter wird dann die verbleibenden Sensoren so ausrichten, daß weiterhin eine vollständige Überwachung des interessierenden Raumes ermöglicht wird.

Das erfindungsgemäße Filter ist also in hohem Maße ausfallsicher, da, sobald eines der vorgegebenen Elementarfilter ausfällt, die verbleibenden Elementarfilter so ausgerichtet werden, daß weiterhin eine optimale Annäherung an eine vorgegebene Sollfunktion möglich ist. Die Ausrichtung der verbleibenden Elementarfilter kann völlig anders sein, als dies der Fall ist, wenn kein Elementarfilter ausgefallen ist. Diese Kompensationseigenschaft des erfindungsgemäßen adaptiven Filters ermögicht vielfältige Anwendung inbesondere auch in der Luft- und Raumfahrttechnik. Bei den bisherigen Beispielen wurden die Elementarfilter meist als z. B. gaußförmige Funktionen angenommen. Der Begriff Elementarfilter ist jedoch selbstverständlich abstrakt aufzufassen und kann ein ganzes System beschreiben, welches bei Ausfall durch die anderen Elementarfilter (weiteren Teilsyteme) vollständig ersetzt wird.

Weiter ist unter Einsatz des erfindungsgemäßen adaptiven Filters der Aufbau von hierarchischen Datenbanken möglich, bei denen Symbole nicht als Wörter, sondern in Form von Filterparametern und Skalaren (Normalprojektionen) abgespeichert sind.

Beispielsweise kann ein Baum symbolisch durch seine Krone, seinen Stamm und seine Äste dargestellt werden. Jedes dieser Teile kann einzeln als approximierte Funktion oder in hierarchischer Ordnung in der Datenbank abgespeichert werden. Ist nun lediglich ein Teil eines Baumes als Eingabefunktion vorhanden, beispielsweise ein Teil der Krone, so wird zunächst die Krone in der Datenbank aufgefunden und durch die hierarchische Zuordnung auf die übrigen Komponenten des Baumes geschlossen.

Auch die Berechnung fraktaler Dimensionen wird mit Hilfe des erfindungsgemäßen aktiven Filters erleichert. Legt man dem Filter ein Bild vor und koppelt die Filter in solcher Weise, daß das Filter die fraktale Dimension des Eingangsbildes berechnet, so ist das Bild dann anschließend in der Lage, aus einem eingegebenen Grauwertbild das nächstliegende Bild mit gleicher fraktualer Dimension zu ermitteln.

Möglich ist auch die Konzeption eines Roboters, bei dem der Ausfall eines Effektors durch die übrigen Effektoren kompensiert wird. Beispielsweise kann also die Bewegung eines fehlerhaften Gelenks durch eine Ausgleichsbewegung des gesamten Armes kompensiert werden. In diesem Fall stellen die Filter also die Effektoren dar, die in der Lage sind, den Ausfall eines (oder mehrerer) Filters optimal zu kompensieren, so daß die beabsichtigte Bewegung weiterhin ausgeführt werden kann.

Im folgenden wird das adaptive erfindungsgemäße Filter nochmals in seinen Grundlagen mit weiteren Einzelheiten ausführlich beschrieben und anschließend werden weitere Anwendungsmöglichkeiten diskutiert.

Eine Berechnung der Filter $g^i$ mit anderen Mitteln, z.B. analytisch ohne Verwendung des Metriktensors, oder durch Approximation, z.B. durch deterministische oder stochastiche Minimierung einer Energie/Kostenfunktion, ist ausdrücklich eingeschlossen.

Zur Ausführung:

1) Normalprojektion

Die Normalprojektion der Sollfunktion mit jedem Elementarfilter $g^i$ ist das Skalarprodukt der Funktion mit diesem Filter, im diskreten Fall also die Summe über x der Produkte der Sollfunktion I(x) mit $g^i(x)$, im kontinuierlichen Fall das Integral über alle diese Produkte.

2) Zur Matrixinversion

Der benötigte kontravariante Metriktensor ist einfach die Inverse zum vorhandenen kovarianten Metriktensor: Es muß somit eine Matrixinversion durchgeführt werden.

Hierzu werden zwei Verfahren nebeneinander angewandt:

Zum einen die sogenannte Miller-Penrose Pseudo-Inverse, wobei die hierzu benötigten Eigenvektoren und Eigenwerte mit Hilfe des Jacobi-Verfahrens berechnet werden:

Dieses Verfahren besteht darin, die Matrix so zu drehen, daß das jeweils betragsgrößte Nichtdiagonalelement verschwindet.

Dies geschieht solange, bis nur noch die Diagonalelemente übrigbleiben. Dieses Verfahren hat weiterhin den Vorzug, daß das Produkt der berechneten Eigenwerte die Determinante ist, die weiter unten benötigt wird.

Im Falle einer kontinuierlichen Änderung der Eingangsgrößen wäre vermutlich eine Berechnung der Eigenvektoren und Eigengrößen durch Resonanz, wie z.B. von Andrasz Pellionizc im Buch "Neurocomputing 2", Anderson, Pellionizc, editors, vorgeschlagen, zweckmäßiger, weil dann die Konvergenz zu den neuen Werten relativ schnell vonstatten geht, während das Jacobi-Verfahren jedesmal neu beginnt.

Auch bei einer größeren Anzahl von Filtern, die eine größere Dimension der Tensoren nach sich zieht, dürfte es effizientere Verfahren geben.

Als zweite Methode wird eine Gradientenabstiegsmethode angewandt:

Eine Definition der Inversen ist die folgende:

$$M \times Inverse(M) = E,$$

wobei M die Matrix, Inverse(M) die invertierte Matrix, und E die Einheitsmatrix ist.

Wird nun ein System mit der folgenden Energie- oder Kostenfunktion definiert:

$$(M \times Inverse(M) - E) \times (M \times Inverse(M) - E,$$

wobei die Elemente der Matrix Inverse(M) die Unbekannten sind, so können durch ein Gradientenabstiegsverfahren diese Unbekannten berechnet werden. Das System wird bestrebt sein, obige Differenz zu minimieren und so die Unbekannten zu berechnen.

3) Die Berechnung der Abhängigkeit der Projektion auf den Gesamtunterraum von den Parametern der Elementarfilter zieht einige Differenzierungen nach der Kettenregel nach sich, die im Regelfall relativ klassisch sind.

Es wird jedoch auf eine Feinheit hingewiesen:

Eine benötigte Größe ist die Ableitung jedes Elements des kontravarianten Metriktensors nach jedem Element des kovarianten Metriktensors:

Hierzu wird folgende Formel verwendet:

$$a(i,j) = A(j,i)/G.$$

Diese Formel ist klassisch:

a(i,j) ist das Element der i-ten Reihe und j-ten Spalte der invertierten Matrix, im vorliegenden Fall also des kontravarianten Metriktensors, G ist die Determinante des kovarianten Metriktensors. Die Berechnung ist z.B. wie oben unter 2 oder analytisch möglich.

A(j,i) ist das sogenannte Algebräische Komplement zu einem Element b(j,i) des kovarianten Metriktensors. Dieses Komplement wird gebildet, indem man einfach die j-te Zeile und i-te Spalte des kovarianten Metriktensors streicht, die Determinante des Restsystems bildet, und diese dann mit $-1^{j+i}$ multipliziert.

Somit liegt eine Formel für den Zusammenhang zwischen jedem Element a des kontravarianten Metriktensors und jedem Element b des kovarianten Metriktensors vor, und es kann somit jedes Element a nach jedem Element b abgeleitet/differenziert werden.

Die Berechnung der übrigen Größen der Differenzierung nach der Kettenregel ist relativ klassisch.

Die Gesamtänderung, die nun jeder Parameter der Elementarfilter erfährt, damit die Differenz zwischen Projektion und der Sollfunktion selbst abnimmt, wird nun dadurch berechnet, daß

a) für jede Dimension x die Abhängigkeit der Differenz von jenem Paramenter hergeleitet wird;
b) die Änderung daraus berechnet wird, die notwendig wäre, damit in jener Dimension x die Differenz kleiner wird;
c) und schließlich die Gesamtänderung dadurch berechnet wird, daß über alle Änderungen aufsummiert wird. Punkt C geht von euklidischen Parameterräumen aus, jedoch sind auch nichteuklidische Parameterräume durchaus vorstellbar. In diesem Falle kommen andere Messungen der Differenz und somit auch andere Summierungsverfahren zum Einsatz.

Es sind auch Eingangsräume vorstellbar, die nichteuklidisch sind, z.B. Oberfläche einer Kugel.

Neben dem Gradientenabstiegsverfahren ist es durchaus vorstellbar, daß ein stochastisches Verfahren wie Simulated Annealing oder Mean Field Annealing oder andere Verfahren, wie Graduated Non-Convexity (Blake & Zisserman, Visual Reconstruction), oder auch anders korrigiertee Energiefunktionen, wie z.B. mit Hilfe von Phi-Funktionen (Geman and Geman), zum Einsatz kommen müssen, wenn die Differenz zwischen Projekten und der Sollfunktion bzw. die daraus gebildete Energiefunktion im Parameterraum mehrere lokale Minima besitzt.

Anwendungsbeispiele aus dem Bereich der Bildverarbeitung:

Texturklassifikation:

Je ein Filter lernt eine Textur.

Wird nun eine unbekannte Textur jedem der Filter eingegeben, so wird jedes Filter einen Ausgangswert liefern. Das Filter, dessen gespeicherte Textur der Unbekannten am ähnlichsten ist, wird den größten Ausgangswert liefern, somit kann die Textur dieser Klasse zugeordnet werden.

Berechnung des optischen Flusses:

Man legt dem Filter eine Serie von Bildern vor, die das Filter als dreidimensionale Funktion auffaßt. Das Filter berechnet nun den Ausgangswert dergestalt, daß dieser für jeden Bildpunkt der Serie von Eingangsbildern den optischen Fluß an dieser Stelle ausgibt.

Berechnung von fraktalen Dimensionen:

Man legt dem Filter ein Bild vor und koppelt die Filter in solcher Weise, daß das Filter die fraktale Dimension des Eingangsbildes berechnet. Das Filter ist dann anschließend in der Lage, aus einem eingegebenen Grauwertbild das nächstliegende Bild mit gleicher fraktalen Dimension zu ermitteln.

Stereobildverarbeitung:

Man legt dem Filter eines der beiden Bilder vor, das Filter erlernt das Bild. Wird nun dem Filter anschließend das andere Bild vorgelegt, so kann das Filter aus der Verschiebung der Unterfilter ein dreidimensionales Bild des Bildinhaltes ermitteln.

Mustererkennung:

Wie Texturerkennung; kann z.B. zur lageunabhängigen Erkennung von Gesichtern auch dreidimensional durchgeführt werden: Die hier verwendeten Elementarfilter sind dann Filter im dreidimensionalen Raum und wiederum beliebig. Im vorliegenden Fall sind z.B. dreidimensionae Gaborfilter vorstellbar, die sich dann so anordnen, daß die Gesichtsoberfläche optimal dargestellt wird, die Filter dabei also relativ flach werden.

Grundsätzlich ist bei allen Klassifizierungsaufgaben auch eine Anzahl an Sollfunktionen vorstellbar, die geringer ist als die Anzahl der einzelnen Klassen, im Extremfall nur eine. Diese Sollfunktion(en) ist (sind) dann eine Funktion (en) der Soll-funktionen der einzelnen Klassen oder anderer für die Unterscheidung der Klassen notwendigen Größen.

Dies ist dort von Belang, wo die Anzahl der Klassen erheblich ist, z.B. bei Gesichtserkennung, und somit Unterentscheidungen, z.B. über Vergleiche bestimmter Gesichtspartien, die Entscheidung beschleunigen, sicherer machen, Speicherbedarf reduzieren, und/oder das Verfahren in anderer Weise optimieren. U.U. kann die Sollfunktion auch die Differenz zwischen zwei Mustern/Klassen sein.

Regelungstechnik:

Man legt dem Filter Beispiele des gewünschten Regelverhaltens in Form von Sätzen von Eingangsgrößen mit gewünschten Ausgangsgrößen vor. Das Filter berechnet aus diesen Beispielen das gewünschte generelle Regelverhalten.

Man legt dem Filter Beispiele des Verhaltens eines unbekannten Systems in Form von Sätzen von Eingangsgrößen mit dazugehörigen Ausgangsgrößen vor. Das Filter berechnet aus diesen Größen das generelle Verhalten des unbekannten Systems.

Stochastische Systeme:

Die eingegebene Sollfunktion kann auch eine Wahrscheinlichkeitsverteilung oder ein Histogramm sein, so daß das Filter auch stochastische Systeme nachbilden/modellieren oder ersetzen kann; da das Filter dynamisch ist, kann es auch einer sich zeitlich ändernden Histogrammverteilung folgen, bei entsprechender Realisierung in Echtzeit, es ist somit eine echte Alternative zur Modellierung von Wahrscheinlichkeitsverteilungen mit Hilfe der Fischer Informations Metrik, bzw. der Minimierung der Kullback-Leibler Entropie, worauf obige Metrik beruht. Somit kann das Filter zeitaufwendige stochastische Lernsysteme, wie z.B. die Boltzmann-Maschine von Hinton & Sejnovski (Rumelhart and MacCleland, Parallel Distributed Processing, the MIT-Press), ersetzen. Der Einsatz einer solchen oder anderer informationstheoretischer Metriken/Normen zur Berechnung oder Definition der Differenz ist aber möglich.

Ist auch nach Minimierung der Differenz diese noch so groß, so können nach Belieben weitere Elementarfilter beliebiger Art hinzugefügt werden, oder Filter durch andere ersetzt werden, bis die Differenz für den jeweiligen Anwendungsfall genügt. Das System wird dann nicht wieder zeitraubend von vorne beginnen, sondern vom bereits erreichten Resultat weiter arbeiten, umgekehrt kann man natürlich auch Filter entfernen, wenn die Ansprüche niedriger liegen, als man anfangs dachte; weiterhin wird das System bei Ausfall eines oder mehrerer Elementarfilter die Parameter der Übrigen so neu berechnen, daß diese wieder optimal angeordnet sind, und somit den Ausfall soweit als möglich kompensieren.

Wirtschaft:

Man gibt dem Filter Zeitfolgen aus der Vergangenheit, z.B. Börsenkurse, ein. Das Filter wird, wenn es bereit ist, und wenn alle die Kurse eingegeben wurden, die für die Zukunft wichtig sind, aus eingegebenen Kursen der jüngsten Vergangenheit den wahrscheinlichsten zukünftigen Kurs berechnen.

Luft- und Raumfahrttechnik:

Da das Filter immer die bestmögliche Berechnung durchführt, die mit den gegebenen Elementarfiltern möglich ist, wird bei Ausfall eines oder mehrerer Filter die anderen bestmöglich den Ausfall kompensieren. Somit kompensiert das Filter den Ausfall bestimmter Teilsysteme, nämlich einer Anzahl von Elementarfiltern, innerhalb gewissen Grenzen (Fachwort hierfür ist Graceful Degradation).

Datenspeicherung:

Ein Gesamtsystem, bestehend aus mehreren, auch hierarchich angeordneten Filtern erlernt z.B. visuell eingegebene Objekte, unterteilt sie in Unterobjekte, dies auch hierarchisch, und legt sie anschließend gemäß der ermittelten geometrischen und sonstigen Beziehungen im Speicher ab. Auch nichtgeometrische/nichträumliche Beziehungen können hier verwendet werden, soweit sie in geometrische Beziehungen übersetzt werden können. Dies ermöglicht es dem Benutzer, z.B. zu einem eingegebenen Begriff zugehörige Begriffe nennen zu können, wie verwandte Begriffe, untergeordnete Begriffe und übergeordnete Begriffe. Ordnet ein Benutzer einem Satz von Begriffen eine andere Struktur als ein anderer ein, so kann das System die jeweilige Struktur abbilden und dem jeweiligen Benutzer seine Struktur zur optimierten Datenabfrage zur Verfügung stellen. Aus der abgelegten Struktur sind auch Rückschlüsse auf den jeweiligen Benutzer selbst möglich.

Berechnungen:

Ist die Struktur eines zu berechnenden Gesamtergebnisses derart, daß es als geometrisches Objekt als Funktion mehrerer voneinander abhängiger Berechnungen dargestellt werden kann, so kann das Filter auch zur Berechnung dieser Größen herangezogen werden.

Ist ein Objekt im Bildbereich in mehrere Einzelobjekte zerlegbar (z.B. Baum in Krone und Stamm), so kann jeweils ein Filter, ein über eine Helligkeitsverteilung als Sollfunktion eingegebenes Unterobjekt in Bildern erkennen, dies einem übergeordneten Gesamtsystem melden, das daraufhin die anderen Filter einschaltet, die zur Erkennung der anderen Einzelobjekte notwendig sind. (Bespielsweise erkennt das Filter, das optimal auf Baumkronen reagiert, in einem Bild eine Baumkrone, so meldet es dies dem System BAUM, zu dem es gehört; dieses schaltet nun das Filter ein, da optimal auf Baumstämme reagiert, damit dieses unterhalb der Krone nach einem Stamm suchen kann; findet dieses Filter den Stamm, meldet es dieses dem übergeordneten System BAUM, das nun melden kann, BAUM IM BILD GEFUNDEN.)

Selbstver- ständlich kann ein Filter auch zu mehreren Gesamtsystemen gehören, z.B. das Filter RAD zum Gesamtsystem FAHRRAD und zum Gesamtsystem MOTORRAD, oder ein Gesamtsystem kann mehrere alternative Unterfilter besitzen, z.B. BAUM kann Untersystem KRONERUND und KRONEKONISCH, z.B. für Nadelbäume, besitzen. Natürlich können sämtliche dieser Filter auch hierarchisch aufgebaut werden, z.B. ZWEIG-AST-KRONE-BAUM-WALD.

Hat ein Filter einmal die Sollfunktion erlernt, so kann man auch die Parameter in bestimmten Grenzen variierbar machen, z.B. mit einem gemeinsamen Größenkoeffizienten multiplizieren, um Entfernungsunterschiede auszugleichen, oder bestimmte Verzerrungen zuzulassen, um verschiedene Blickwinkel zu ermöglichen; Berechnungen z.B. über projektive Geometrie.

Als Maß für die Distanz zwischen Projektion und Solfunktion kann im Falle von Wahrscheinlichkeitsverteilungen auch die Kullback-Leibler-Entropie oder ein anderes informationstheoretisches Maß verwendet werden.

Objekterfassung/Tracking:

Ein Filter bzw. ein System, bestehend aus mehreren Filtern, ist in der Lage, mehrere Objekte, die beispielsweise auf einem Radarschirm oder Fernsehschirm zu sehen sind, und die sich sogar teilweise überlappen dürfen, voneinander zu unterscheiden, wobei, wie bereits oben erwähnt, die Unterscheidungskriterien beliebige Funktionen der Parameterwerte der Elementarfilter und somit beliebige Funktionen der Helligkeitsverteilung oder dessen Äquivalent sein können. Das System ist dann weiterhin in der Lage, jedem dieser Objekte zu folgen, eine Bezeichnung zuzuordnen, ggf. zu identifizieren, u.U. einen oder mehrere Sensoren nachzuführen (Kameras, Zielverfolgungsradar, etc.), und das Gesamtsystem zu anderen weiteren Maßnahmen, wie z.B. einem Alarm, zu veranlassen. Natürlich können bei entsprechenden antrainierten Sollfunktionen auch Vorhersagen über zukünftiges Verhalten, wie z.B. zukünftiger Trajektorienverlauf, Gefahr von Zusammenstößen etc. getroffen werden.

Das Filter ist auch in der Lage, anhand von Bewegungsanalysen Bewegungsschäden an einem Patienten festzustellen, wenn bestimmte Bewegungsabläufe und -sequenzen für diese Schäden typisch sind. (Klassifizierung von Blutzellen etc. sind Anwendungen, die unter die oben erwähnte Texturklassifikation fallen.)

Bezug zur künstlichen Intelligenz:

Das Filter kann in verschiedenster Form im Bereich der KI eingesetzt werden, wie weiter oben schon im Bereich Objekterkennung gezeigt wurde.

Zur Ojekterkennung/Mustererkennung:

Das Filter wird auch dann in der Lge sein, ein Ojekt zu erkennen, wenn es teilweise verdeckt ist, wobei natürlich der Grad der akzeptablen Verdeckung vom Einzelfall abhängt. Weiterhin kann zum Beispiel, wenn das Filter BAUMKRONE ein zwiespältiges Ergebnis liefert, das übergeordnete Filter BAUM angerufen werden, das nun das Filter BAUMSTAMM zuschaltet, um unterhalb der Krone den STAMM zu finden, wird dieser gefunden, so wird das Ergebnis des Filters BAUMKRONE verifiziert, wenn nicht, dann verfälscht.

Somit erlaub der Einsatz von hierarchischen Filterstrukturen auch eine maximale Ausnutzung ggf. vorhandener Redundanz, wobei die vorhandenen Redundanzen auch mit Hilfe solcher Filter gefunden werden können.

Erlernt ein Filter ein Objekt, und stellt man fest, daß die Parameterwerte der Elementarfilter nach dem Erlernen sich irgenewie gruppieren lassen, z.B. Filter mit starkem Überlappungsbereich werden gruppiert, oder Filter mit bestimmten Frequenzen, oder Verhältnisse der Parameterwerte zueinander, z.B. konstante Abstände, so lassen sich diesen Gruppen Konzepte zuordnen, denen evtl. in der Außenwelt entsprechende Objekte entsprechen: Beispielsweise hat eine BAUMKRONE eine andere fraktale Dimension und eine andere Lage als der BAUMSTAMM, so daß das Filter in der Lage ist, die Elementarfilter, die diesen beiden Ojekten angehören, zu trennen, zwei verschiedenen Objekten zuzuordnen, und das Verhältnis der beiden Objekte zueinander festzustellen und zu erlernen. Dies kann natürlich auch wiederum über mehrere Hierarchie-Ebenen verlaufen, wie z.B. WALD-BÄUME-BAUMKRONE-ÄSTE-ZWEIGE-BLÄTTER. Das Filter kann auch andere Anhaltspunkte nehmen, z.B. Phasesprünge an gleicher Stelle, oder klassische Konturdetektionsalgorithmen, um Unterobjekte voneinander zu trennen.

Das Filter wird sodann die Objekte abspeichern, zusammen mit zugehörigen Parameterwerten, und ihren räumlichen Beziehungen zueinander, und wird damit in der Lage sein, seine Umgebung zu analysieren und zu erfahren, und so einem übergeordneten System Anhaltspunkte über das Verhalten geben zu können.

Dies ist dann z.B. interessant, wenn das Gesamtsystem ein unbemanntes Roboterfahrzeug ist, das auf unbekanntem Territorium, z.B. auf anderen Planeten, eingesetzt wird, wo es den Erbauern nicht möglich ist, im vornherein festzustellen, mit welcher Umgebung und welchen Objekten das Roboterfahrzeug nach der Landung konfrontiert sein wird.

Man kann z.B. durch Vorauswahl der Elementarfilter das Filter auch so programmieren, daß es auf bestimmte Objekte seiner Umgebung bevorzugt reagiert und sich somit seine Sollfunktion selbst auswählt, dies könnten z.B. Objekte sein, die sich bewegen, während statische Objekte ignoriert werden.

Es können grundsätzlich alle Objekte selektiert werden, deren Auswahlkriterien sich irgendwie durch Funktionen der Filterparamenter ausdrücken lassen, wie z.B. bestimmte Bewegungsmuster, Bewegungsfolgen, Helligkeitsverteilungen, Texturstrukturen etc.

Auch nach dem Erlernen der Sollfunktion kann eine solche Selektion durchgeführt werden, z.B. für Rettungsroboter in Kernkraftwerken und bei Waldbränden oder für Überwachungsroboter.

Wird die Kamera auf das Roboterfahrzeug selbst gerichtet, so erlernt es seine eigene äußere Struktur und wäre somit fähig, durch Vergleich mit der erlernten Struktur Beschädigungen von außen festzustellen, dies dem übergeordneten System zu melden, daß dann weitere Maßnahmen, wie z.B. das Abnehmen von Blenden zur weiteren Analyse, oder bestimmte Reparaturen, anordnen kann. Das System wäre weiterhin fähig, den genauen Ort der Beschädigung durch sukzessives Absteigen über mehrere Filter-Hierarchie-Ebenen festzustellen, durch Vergleich mit einer internen Texturdatenbank evtl. die Art des Schadens festzustellen, und somit das Gesamtsystem zu weiteren spezifischeren Maßnahmen zu veranlassen.

Generell ist das Filter gegen Rotation, Translation, und/oder Skalierung invariant, wenn man wie folgt vorgeht: Hat das Filter einmal die Sollfunktion/das Ojekt erkannt, und legt man ihm nun ein zu erkennendes Muster vor, so erlaubt man dem Filter, sich insgesamt gegenüber dem Bild zu drehen, zu verschieben, oder in der Größe zu verändern, d.h. man versucht wiederum, die Differenz zwischen Projektion und Bild zu minimieren, wobei hier aber nur eine Rotation, Verschiebung oder Skalierung des Gesamtfilters erlaubt ist.

Natürlich kann man auch, wie bereits erwähnt, bestimmte Veränderungen der Parameterwerte der Einzelfilter zulassen, wenn man gegen bestimmte Verzerrungen invariant bleiben will.

Zur Stereobildverarbeitung:

Es ist mit dem Filter weiter möglich, fraktale Disparitätskarten anzulegen, die z.B. zur dreidimensionalen Rekonstruktion von fraktalen Objekten, wie z.B. Büschen, dienen können.

Bildsynthese/Grafik/CAD/CAM:

Hat man einmal die charakteristischen Parameter eines Objekts erlernt, z.B. die eine Frauenschopfes, so kann man damit beliebig Bilder synthetisch herstellen, verfremden, verändern, verzerren, rekombinieren, komponieren. Mann kann in extrem kurzer Zeit Grafikanimation mit extrem hoher Qualität durchführen, da nicht jedes Pixel eines Bildes manipuliert zu werden braucht, sondern nur die Parameterwerte der zugeordneten Elementarfilter.

Bildkompression:

Das Einzelfilter ermöglicht eine Bildkompression in der Größenordnung von 80-100 : 1. Bei Komprimieren von Bildfolgen ähnlichen Inhalts steigt diese noch, da in diesem Fall nur noch die Änderungen der Parameterwerte übermittelt werden müssen. Natürlich kann die Kompensation auch mit Hilfe von dreidimensionalen Elementarfiltern optimiert werden.

Weitere Anwendungsmöglichkeiten:

Das Filter kann auch verwendet werden, um aus dem Eingangsraum bestimmte, bekannte Strukturen sowie Kombinationen/Funktionen hiervon herauszufiltern, um nur neue, unbekannte Strukturen übrig zu lassen.

Anwendungen liegen hierbei in der Spracherkennung von gesprochenen Lauten, im Erkennen von Gesetzmäßigkeiten und bei der Identifizierung von Sprechern.

Das allgemeine Lösen von Optimierungsaufgaben, z.B. der Entwurf und das Management von räumlich verteilten Systemen, von Funkzellen eines Mobilnetzes, von Kraftwerken, Transformatoren und Verteilern eines Energienetzes, von Depots eines Transportunternehmens, ist folgendermaßen möglich: Jedem Netzknoten wird ein Elementarfilter zugeordnet, z.B. ein Gaußfilter, bei dem der Mittelwert individuell variabel ist, während sich die Standardabweichung bei jedem Filter nur im gleichen Maße ändern kann. Die Elementarfilter werden sich so anordnen, daß ein vorgegebener Raum, z.B. die Bundesrepublik, optimal abgedeckt wird; fällt ein Knoten aus, so ordnen sich die übrigen Knoten selbständig so um, daß der Raum wieder optimal abgedeckt wird; dies kann im Falle z.B. eines Funknetzes auch dadurch geschehen, daß die Standardabweichung, die ja die Funkleistung modelliert, von bestimmten Elementarfiltern einfach erhöht wird: Funkzellen sind ja in der Regel nicht mobil, und können somit ihren Standort nicht ändern.

Natürlich können auch Verzerrungen der unterliegenden Metrik in diesen Optimierungsaufgaben berücksichtigt werden; werden z.B. die Entfernungen anhand der Transportzeiten definiert, haben Depots in der Nähe von Autobahnen größere Versorgungsbereiche: Diese Verzerrungen können durch Verzerrungen des Eingangsraums bzw. durch Verzerrungen der Filterparameter modelliert werden.

Weitere Anwendungsmöglichkeiten:

Daten/Sensor-Fusion: Decken verschiedene Sensoren/Informationsquellen überlappende Bereiche ab, z.B. Infrarot-Aufnahmen und Aufnahmen im sichtbaren Bereich des gleichen Geländes, so können bei Ausfall des einen Sensors die Parameter des oder der anderen Sensoren so verändert werden, daß der zu überwachende Bereich weitestgehend abgedeckt wird, weiterhin kann das Filter unterliegende statistische Zusammenhänge von Daten aus verschiedenen Quellen erfassen und modellieren.

Ist die Anzahl der Elementarfilter in irgendeiner Anwendung zu groß, so daß die notwendigen Berechnungen zu langwierig und/oder kompliziert werden, so können wir die Elementarfilter beliebig zu Gruppen zusammenfassen, die jeweilige Gesamtprojektion der gruppierten Filter berechnen, und die Gruppen wiederum als höhere Elementarfilter auffassen, mit einem neuen Metriktensor, der die Beziehungen der Gruppen untereinander ausdrückt; auch dies kann sukzessive hierarchisch durchgeführt werden. In diesem Falle wird den einzelnen Gruppen nicht das Konzept eines zugehörigen Objektes zugeordnet.

Wird die Sollfunktion in bestimmten Anwendungen kontinuierlich verändert, so empfiehlt es sich unter Umständen,

die Elementarfilter rekursiv zu implementieren.

Zur Stereobildverarbeitung:

Neben dem vorgeschlagenen Verfahren ist es weiterhin möglich, die beiden Bilder als Abbildungen des gemeinsamen dreidimensionalen Raums zu betrachten, und die Sollfunktion und Berechnungen daraufhin durchzuführen, z.B. mit dreidimensionalen Gabor-Filtern. Der Parameterraum kann auch nicht-euklidisch bzw. das Koordinatensystem nicht-kartesisch sein, in welchem Falle die notwendigen Änderungen an den Parameterwerten nicht unabhängig sind, sondern wiederum über einen anderen Metriktensor verknüpft sind. In diesem Falle muß diese Verknüpfung in den Berechnungen berücksichtigt werden. Auch der Eingangsraum muß nicht-euklidisch sein bzw. das Koordinatensystem nicht-kartesisch. Beispielsweise ist durchaus eine Sollfunktion vorstellbar, die sich auf Koordinaten einer Kugeloberfläche bezieht, z.B. bei Navigationsaufgaben in Luftfahrzeugen, oder anderen nicht-euklidischen Räumen, z.B. bei Berechnungen/Auswertungen, die sich auf Radardaten beziehen, bei relativitätstheoretischen Untersuchungen, bei Auswertung von Daten der medizinischen Bildverarbeitung etc.

## Patentansprüche

**1.** Adaptives Filter zum Approximieren einer eingelesenen in einem Funktionenraum liegenden Sollfunktion F, enthaltend einen Satz von n Elementarfiltern $g_b$, wobei n eine ganze Zahl $\geq 1$ ist, die Elementarfilter einen Unterraum im Funktionenraum aufspannen, die Parameter der Elementarfilter veränderbar sind und das Filter Mittel zum Ausführen folgender Operationen aufweist:
Berechnen der Normalprojektionen der Sollfunktion F auf jeden Elementarfilter und Multiplizieren der so erhaltenen Projektionsgrößen $A_a$ jeweils mit dem aus dem Satz Elementarfiltern gebildeten kontravarianten Metriktensor $g^{ab}$, um dadurch die Projektion der Sollfunktion F auf den aufgespannten Unterraum zu erhalten, deren Differenz D zur Sollfunktion F als Funktion der Elementarfilter und des Metriktensors gemäß folgender Formel erfaßt wird:

$$D = F - \sum_a \sum_b A_a \, g^{ab} \, g_b$$

um dadurch die Differenz D über Veränderung der Elementarfilterparameter mittels üblicher deterministischer oder stochastischer Berechnungsmethoden zu mininieren, wobei sich die gewünschte approximierte Funktion aus der Superpositionierung der über die Minimierung eingestellten Elementarfilter gemäß folgender Formel ergibt:

$$\sum_a \sum_b A_a \, g^{ab} \, g_b \; .$$

**2.** Adaptives Filter zum Approximieren einer eingelesenen, in einem Funktionenraum liegenden Sollfunktion F, enthaltend einen Satz von n Elementarfiltern $g_b$, wobei n eine ganze Zahl $\geq 1$ ist, die Elementarfilter einen Unterraum im Funktionenraum aufspannen, die Parameter der Elementarfilter veränderbar sind und das Filter Mittel zum Ausführen folgender Operationen aufweist:
Berechnen der Normalprojektionen der Sollfunktion F auf jeden Elementarfilter, Berechnen der Projektion A der Sollfunktion F auf den von den Elementarfiltern aufgespannten Unterraum durch Lösen des überbestimnten Gleichungssystems

$$MX = F$$

mittels klassischer Verfahren zur Lösung des Least Squares-Problems, wobei M eine aus den Elementarfiltern gebildete Matrix ist und X der zu bestimmende Satz der Koeffizienten der Projektion A ist,
um dadurch die Differenz D

$$D = |F - A|$$

über Veränderung der Elementarfilterparameter mittels üblicher deterministischer oder stochastischer Berechnungsmethoden zu minimieren, wobei sich die gewünschte approximierte Funktion aus der Superpositionierung der über die Minimierung eingestellten Elementarfilter entsprechend einer der folgenden Zusammenhänge ergibt:

$$\sum_a A^a g_a$$

$$\sum_a A_a g^a .$$

**3.** Adaptives Filter zum Approximieren einer eingelesenen, in einem Funktionenraum liegenden Sollfunktion F, enthaltend einen Satz von n Elementarfiltern $g_b$, wobei n eine Zahl ≥ 1 ist, die Elementarfilter einen Unterraum im Funktionenraum aufspannen, die Parameter der Elementarfilter veränderbar sind und das Filter Mittel zum Ausführen folgender Operationen aufweist:
Berechnen der Normalprojektionen der Sollfunktion F auf jeden Elementarfilter, Verändern eines in dem von den Elementarfiltern aufgespannten Unterraum liegenden Vektors A (t) bis dessen Normalprojektionen auf die Elementarfilter den Normalprojektionen der Sollfunktion F auf den Unterraum entsprechen, d.h. bis der Fehler E

$$E = \sum_a \left(A_a - \sum_b g_{ba} A^b(t)\right)^2$$

in Abhängigkeit von $A^b(t)$
minimal ist, um dadurch die Differenz D

$$D = |F - A(t)|$$

über Veränderung der Elementarfilterparameter mittels üblicher deterministischer oder stochastischer Berechnungsmethoden zu minimieren, wobei sich die gewünschte approximierte Funktion aus der Superpositionierung der über die Minimierung eingestellten Elementarfilter gemäß folgender Formel ergibt:

$$\sum_a A^a g_a .$$

**4.** Adaptives Filter zum Approximieren einer eingelesenen, in einem Funktionenraum liegenden Sollfunktion F, enthaltend einen Satz von n Elementarfiltern $g_b$, wobei n eine ganze Zahl ≥ 1 ist, die Elementarfilter einen Unterraum im Funktionenraum aufspannen, die Parameter der Elementarfilter veränderbar sind und das Filter Mittel zum Ausführen folgender Operationen aufweist:
Berechnen der Normalprojektionen der Sollfunktion F auf jeden Elementarfilter,
Berechnen der adjungierten Elementarfilter zu den den Unterraum aufspannenden Elementarfiltern durch Minimieren des Fehlers E

$$E = \sum_a \left( g_a - \sum_b g_{ab} \, g^b(t) \right)^2$$

mittels herkömmlicher Berechnungsverfahren (z.B. "Gradientenabstiegsverfahren"), um dadurch die Differenz D

$$D = \left| F - \sum_a A_a \, g^a(t) \right|$$

bzw. allgemein $D = f\left( F, h \,\middle|\, \sum_a A_a \, g^a(t) \right)$

mittels üblicher deterministischer (z.B. "Gradientenabstiegsverfahren") oder stochastischer (z.B. "simulated annealing, Monte Carlo-Verfahren") Berechnungsmethoden zu minimieren, wobei sich die gewünschte approximierte Funktion aus der Superpositionierung der über die Minimierung eingestellten Elementarfilter gemäß folgender Formel ergibt:

$$\sum_a A_a \, g^a \quad .$$

**5.** Adaptives Filter zum Approximieren einer eingelesenen in einem Funktionenraum liegenden Sollfunktion F, enthaltend einen Satz von n Elementarfiltern $g_b$, wobei n eine ganze Zahl $\geq 1$ ist, die Elementarfilter einen Unterraum im Funktionsraum aufspannen, die Parameter der Elementarfilter fest eingestellt sind, das Produkt jedes Elementarfilters mit dem aus dem Satz Elementarfiltern gebildeten kontravarianten Metriktensor $g^{ab}$ gespeichert ist und das Filter Mittel zum Ausführen folgender Operationen aufweist:
Berechnen der Normalprojektion $A_a$ der Sollfunktion F auf jeden Elementarfilter und Berechnen der Projektion der Sollfunktion auf den aufgespannten Unterraum gemäß folgender Formel:

$$\sum_a \sum_b A_a \, g^{ab} \, g_b$$

und Verwenden dieser Projektion als approximierte Funktion.

**6.** Adaptives Filter nach Anspruch 5, bei dem eine Vielzahl von Elementarfiltersätzen vorhanden ist, die jeweils unterschiedliche Unterräume aufspannen, die Projektion der Sollfunktion auf jeden dieser Unterräume berechnet wird und als approximierte Funktion diejenige Projektion verwendet wird, deren Differenz D zur Sollfunktion F minimal ist.

**7.** Adaptives Filter nach Anspruch 6, dadurch gekennzeichnet, daß jede Differenz D gemäß folgender Formel bestimmt wird:

$$D = \left| F - \sum_a \sum_b A_a \, g^{ab} \cdot g_b \right| .$$

**8.** Adaptives Filter nach mindestens einem der Ansprüche 1 bis 7, bei dem der Elementarfilter eine Gaußfunktion ist mit den Parametern Standardabweichung und Mittelwert.

**9.** Adaptives Filter nach mindestens einem der Ansprüche 1 bis 8, bei der der Elementarfilter eine Gaborfunktion ist mit den Parametern Standardabweichung, Mittelwert, Phase und Frequenz.

**10.** Adaptives Filter nach mindestens einem der Ansprüche 1 bis 8, bei dem der Elementarfilter folgender Funktion entspricht:

$$g_a(X_i \, , \, i \in \{1, \ldots N\}) = \mathrm{sigmoid}\left( \sum_i W_{ia} X_i + \Theta \right),$$

wobei $W_{ia}$, $\theta$ den Parametern der Basisfunktion $g_a$ enstprechende Skalare sind, mit sigmoid (a) = $1/(1 + e^{-a})$.

**11.** Adaptives Filter nach mindestens einem der Ansprüche 1 bis 8, bei dem der Elementarfilter folgender Funktion entspricht:

$$g_a(X_i \, , \, i \in \{1 \ldots N\}) = \tanh\left( \sum_i W_{ia} X_i + \Theta \right),$$

wobei $W_{ia}$, $\theta$ den Parametern der Basisfunktion $g_a$ enstprechende Skalare sind.

**12.** Adaptives Filter nach mindestens einem der vorhergehenden Ansprüche, bei dem die Elementarfilter untereinander linear unabhängig sind.

**13.** Adaptives Filter nach mindestens einem der vorhergehenden Ansprüche, bei dem die Sollfunktion sowohl bezüglich des Wertebereichs als auch bezüglich der Auflösung diskret eingelesen wird.

**14.** Adaptives Filter nach mindestens einem der vorhergehenden Ansprüche, bei dem die aufgefundenen Parametereinstellungen ausgegeben werden.

**15.** Adaptives Filter nach mindestens einem der vorhergehenden Ansprüche, bei dem die Sollfunktion an unvollständig erfaßten Orten durch in der Umgebung liegende Sollwertfunktionswerte und zusätzlichem, etwa gaußverteilten Rauschen angenähert wird.

**16.** Adaptives Filter nach mindestens einem der vorhergehenden Ansprüche, bei dem das verwendete Berechnungsverfahren ein Gradientenabstiegsverfahren (deterministisch) ist.

**17.** Adaptives Filter nach mindestens einem der vorhergehenden Ansprüche, bei dem die Sollfunktion F ein optisches Signal ist.

**18.** Adaptives Filter nach mindestens einem der vorhergehenden Ansprüche, bei dem die Sollfunktion F ein Videosignal ist.

**19.** Adaptives Filter nach mindestens einem der vorhergehenden Ansprüche, bei dem die Elementarfilter optische Filter sind.

**20.** Adaptives Filter nach mindestens einem der vorhergehenden Ansprüche, bei dem die Sollfunktion ein Audiosignal ist.

**21.** Adaptives Filter gemäß Patentanspruch 17, 18 oder 19, bei dem die approximierte Funktion als Teil eines bandbreitereduzierten HDTV-Signals übertragen wird.

## Claims

**1.** Adaptive filter for the approximation of a read-in set function F, lying in the function space and containing a set of n elementary filters $g_b$, where n is an integer $\geq 1$, the elementary filters cover a sub-space within the function space, the parameters of the elementary filters are variable and the filter has means for performing the following operations:
calculating the normal projections of the set function F on each elementary filter and multiplying the projection quantities $A_a$ thus obtained respectively by the counter-variant metric tensor $g^{ab}$ formed from the set of elementary filters, in order thereby to obtain the projection of the set function F on the sub-space covered, of which the difference D from the set function F is derived as a function of the elementary filter and the metric tensor in accordance with the following formula:

$$D = F - \sum_a \sum_b A_a g^{ab} g_b$$

in order thereby to minimise the difference D by changing the elementary filter parameters by means of conventional deterministic or stochastic methods of calculation, the desired approximated function being obtained from the superposition of the elementary filters set by minimisation in accordance with the following formula:

$$\sum_a \sum_b A_a g^{ab} g_b .$$

**2.** Adaptive filter for the approximation of a read-in set function F lying in a function space and containing a set of n elementary filters $g_b$, n being an integer $\geq 1$, the elementary filters covering a sub-space within the function space, the parameters of the elementary filters being variable and the filter having means for performing the following operations: calculating the normal projections of the set function F on each elementary filter, calculating the projection A of the set function F on the sub-space covered by the elementary filters by solving the over-determined equation system

$$MX = F$$

by means of classical methods for solving the least squares problem, where M is a matrix formed from the elementary filters and X is the set of co-efficients of the projection A to be determined,
in order thereby to minimise the difference D

$$D = |F - A|$$

by changing the elementary filter parameters by means of conventional deterministic or stochastic methods of

calculation, the desired approximated function being obtained from the superposition of the elementary filters set by the minimisation in accordance with one of the following relationships:

$$\sum_a A^a g_a$$

$$\sum_a A_a g^a \text{ .}$$

3. Adaptive filter for the approximation of a read-in set function F, lying within a function space and containing a set of n elementary filters $g_b$, where n is an integer ≥ 1, the elementary filters cover a sub-space within the function space, the parameters of the elementary filter are variable and the filter has means for performing the following operations: calculation of the normal projections of the set function F on each elementary filter, changing a vector A (t) lying in the sub-space covered by the elementary filters until its normal projections on the elementary filters correspond to the normal projections of the set function F on the sub-space, i.e. until the error E

$$E = \sum_a \left(A_a - \sum_b g_{ba} A^b (t)\right)^2$$

is a minimum depending on $A^b(t)$, in order thereby to minimise the difference D

$$D = |F - A(t)|$$

by changing the elementary filter parameters by means of conventional deterministic or stochastic methods of calculation, the desired approximated function being obtained by superposition of the elementary filters set by the minimisation in accordance with the following formula:

$$\sum_a A^a g_a \text{ .}$$

4. Adaptive filter for the approximation of a read-in set function F, lying in a function space and containing a set of n elementary filters $g_b$, where n is an integer ≥ 1, the elementary filters cover a sub-space within the function space, the parameters of the elementary filter are variable and the filter has means for performing the following operations:
calculating the normal projections of the set function F on each elementary filter,
calculating the elementary filters adjoining the elementary filters which cover the sub-space by minimising the error E

$$E = \sum_a \left(g_a - \sum_b g_{ab} \; g^b(t)\right)^2$$

by means of conventional methods of calculation (e.g. "gradient fall method"), in order thereby to minimise the difference D

$$D = \left| F - \sum_a A_a g^a (t) \right|$$

and generally $D = f(F, h \mid \Sigma A_a g^a (t) \mid)$
by means of conventional deterministic (e.g. "gradient fall method") or stochastic (e.g. "simulated annealing, Monte Carlo method) methods of calculation, the desired approximation being obtained from the superposition of the elementary filter set by the minimisation in accordance with the following formula:

$$\sum_a A_a g^a .$$

5. Adaptive filter for the approximation of a read-in set function lying in a function space and containing a set of n elementary filters $g_b$, n being an integer ≥ 1, the elementary filters covering a sub-space within the function space, the parameters of the elementary filter are fixed, the product of each elementary filter is stored with the counter-variant metric tensor $g^{ab}$ formed from the set of elementary filters and the filter having means for performing the following operations:
calculating the normal projection $A_a$ of the set function F on each elementary filter and calculating the projection of the set function on the sub-space covered in accordance with the following formula:

$$\sum_a \sum_b A_a g^{ab} g_b$$

and using this projection as the approximated function.

6. Adaptive filter according to claim 5 in which a number of sets of elementary filters is present, each covering different sub-spaces, the projection of the set function on each of these sub-spaces is calculated and is used as an approximated function of that projection, of which the difference D from the set function F is a minimum.

7. Adaptive filter according to claim 6, characterised in that each difference D is determined in accordance with the following formula:

$$D = \left| F - \sum_a \sum_b A_a g^{ab} . g_b \right| .$$

8. Adaptive filter according to at least one of claims 1 to 7, in which the elementary filter is a gaussian function with the parameters of standard deviation and mean value.

9. Adaptive filter according to at least one of claims 1 to 8, in which the elementary filter is a Gabor function with the parameters of standard deviation, mean value, phase and frequency.

10. Adaptive filter according to at least one of claims 1 to 8, in which the elementary filter corresponds to the following function:

$$g_a\left(X_i,\ i \in \{1, \ldots N\}\right) = \text{sigmoid}\left(\sum_i W_{ia}X_i + \theta\right)$$

where w:a, θ are the parameters of the values corresponding to the base function $g_a$, with sigmoid (a) = 1 / (1 + $e^{-a}$).

**11.** Adaptive filter according to at least one of claims 1 to 8 in which the elementary filter corresponds to the following function:

$$g_a\left(X_i,\ i \in \{1, \ldots N\}\right) = \tanh\left(\sum_i W_{ia}X_i + \theta\right)$$

in which $W_{ia}$, θ are the parameters of the values corresponding to the base function $g_a$.

**12.** Adaptive filter according to at least one of the foregoing claims in which the elementary filters are linearly independent of one another.

**13.** Adaptive filter according to at least one of the foregoing claims in which the set function is read-in discretely both with reference to the value range and also with reference to the solution.

**14.** Adaptive filter according to at least one of the foregoing claims in which the parameter settings on which it is based are displayed.

**15.** Adaptive filter according to at least one of the foregoing claims in which the set function is approximated at incompletely determined points by set function values lying in the neighbourhood and additional approximately gaussian-distributed noise.

**16.** Adaptive filter according to at least one of the foregoing claims, in which the method of calculation which is used is a gradient fall (deterministic) method.

**17.** Adaptive filter according to at least one of the foregoing claims, in which the set function F is an optical signal.

**18.** Adaptive filter according to at least one of the foregoing claims in which the set function F is a video signal.

**19.** Adaptive filter according to at least one of the foregoing claims in which the elementary filters are optical filters.

**20.** Adaptive filter according to at least one of the foregoing claims in which the set function is an audio signal.

**21.** Adaptive filter according to claim 17, 18 or 19 in which the approximated function is transmitted as part of a reduced-bandwidth HDTV signal.

## Revendications

**1.** Filtre adaptatif pour l'approximation d'une fonction théorique F entrée et située dans un espace de fonction, comprenant un jeu de n filtres élémentaires $g_b$, n étant un nombre entier ≥ 1, les filtres élémentaires définissant un espace inférieur dans l'espace de fonction, les paramètres des filtres élémentaires étant variables et le filtre comprenant des moyens pour l'exécution des opérations suivantes :
Calcul des projections normales de la fonction théorique F sur chaque filtre élémentaire et multiplication des grandeurs de projection $A_a$ ainsi obtenues par le tenseur métrique contravariant $g^{ab}$ respectivement formé à partir du jeu de filtres élémentaires pour obtenir ainsi la projection de la fonction théorique F sur l'espace inférieur défini

dont la différence D avec la fonction théorique F est déterminée en tant que fonction des filtres élémentaires et du tenseur métrique suivant la formule suivante :

$$D = F - \sum_a \sum_b A_a g^{ab} g_b$$

pour minimiser ainsi la différence D par l'intermédiaire de la variation des paramètres des filtres élémentaires au moyen de méthodes de calcul déterministes ou aléatoires habituelles, la fonction approchée désirée résultant , conformément à la formule ci-après, de la superposition des filtres élémentaires réglés par l'intermédiaire de la minimisation :

$$\sum_a \sum_b A_a g^{ab} g_b.$$

**2.** Filtre adaptatif pour l'approximation d'une fonction théorique F entrée et située dans un espace de fonction, comprenant un jeu de n filtres élémentaires $g_b$, n étant un nombre entier ≥ 1, les filtres élémentaires définissant un espace inférieur dans l'espace de fonction, les paramètres des filtres élémentaires étant variables et le filtre comprenant des moyens pour l'exécution des opérations suivantes :
Calcul des projections normales de la fonction théorique F sur chaque filtre élémentaire, calcul de la projection A de la fonction théorique F sur l'espace inférieur défini par les filtres élémentaires par la résolution du systèmes d'équations redondant

$$MX = F$$

au moyen de méthodes classiques pour résoudre le problème de Least Squares, M étant une matrice formée à partir des filtres élémentaires, et X, le jeu des coefficients de la projection A à déterminer pour minimiser ainsi la différence D

$$D = |F - A|$$

par l'intermédiaire de la variation des paramètres des filtres élémentaires au moyen de méthodes de calcul déterministes ou aléatoires habituelles, la fonction approchée désirée résultant, conformément aux relations ci-après, de la superposition des filtres élémentaires réglés par l'intermédiaire de la minimisation :

$$\sum_a A^a g_a$$

$$\sum_a A_a f^a.$$

**3.** Filtre adaptatif pour l'approximation d'une fonction théorique F entrée et située dans un espace de fonction, comprenant un jeu de n filtres élémentaires $g_b$, n étant un nombre ≥ 1, les filtres élémentaires définissant un espace inférieur dans l'espace de fonction, les paramètres des filtres élémentaires étant variables et le filtre comprenant des moyens pour l'exécution des opérations suivantes :
Calcul des projections normales de la fonction théorique F sur chaque filtre élémentaire, variation d'un vecteur A (t) situé dans l'espace inférieur défini par les filtres élémentaires jusqu'à ce que ses projections normales sur les filtres élémentaires correspondent aux projections normales de la fonction théorique F sur l'espace inférieur, c'est-à-dire jusqu'à ce que l'erreur E

$$E = \sum_a (A_a - \sum_b g_{ba} A^b(t))^2$$

en fonction de $A^b(t)$ soit minimale pour minimiser ainsi la différence D

$$D = |F - A(t)|$$

par l'intermédiaire de la variation des paramètres des filtres élémentaires au moyen de méthodes de calcul déterministes ou aléatoires habituelles, la fonction approchée désirée résultant, conformément à la formule ci-après, de la superposition des filtres élémentaires réglés par l'intermédiaire de la minimisation :

$$\sum_a A^a g_a.$$

**4.** Filtre adaptatif pour l'approximation d'une fonction théorique F entrée et située dans un espace de fonction, comprenant un jeu de n filtres élémentaires $g_b$, n étant un nombre entier ≥ 1, les filtres élémentaires définissant un espace inférieur dans l'espace de fonction, les paramètres des filtres élémentaires étant variables et le filtre comprenant des moyens pour l'exécution des opérations suivantes :
Calcul des projections normales de la fonction théorique F sur chaque filtre élémentaire,
calcul des filtres élémentaires adjoints aux filtres élémentaires définissant l'espace inférieur par minimisation de l'erreur E

$$E = \sum_a (g_a - \sum_b g_{ab}\ g^b(t))^2$$

au moyen de méthodes de calcul habituelles (par exemple « méthode de descente de gradient ») pour minimiser ainsi la différence D

$$D = |F - \sum_a A_a\ g^a(t)|$$

et respectivement de manière générale

$$D = f(F, h\ (\sum_a A_a\ g^a(t))$$

au moyen de méthodes de calcul déterministes (par exemple « méthode de descente de gradient ») ou aléatoires (par exemple « simulated annealing, « méthode de Monte Carlo ») habituelles, la fonction approchée désirée résultant, conformément à la formule ci-dessus, de la superposition des filtres élémentaires réglés par l'intermédiaire de la minimisation :

$$\sum_a A_a\ g^a.$$

**5.** Filtre adaptatif pour l'approximation d'une fonction théorique F entrée et située dans un espace de fonction, comprenant un jeu de n filtres élémentaires $g_b$, n étant un nombre entier ≥ 1, les filtres élémentaires définissant un espace inférieur dans l'espace de fonction, les paramètres des filtres élémentaires étant réglés fixe, le produit de chaque filtre élémentaire par le tenseur métrique contravariant $g^{ab}$ formé à partir du jeu de filtres élémentaires étant mémorisé et le filtre comprenant des moyens pour l'exécution des opérations suivantes :
Calcul de la projection normale $A_a$ de la fonction théorique F sur chaque filtre élémentaire et calcul de la projection de la fonction théorique sur l'espace inférieur défini suivant la formule suivante :

$$\sum_a \sum_b A_a\ g^{ab}\ g_b \quad .$$

et utilisation de cette projection comme fonction approchée.

**6.** Filtre adaptatif selon la revendication 5, dans lequel est prévue une multiplicité de jeux de filtres élémentaires qui définissent à chaque fois des espaces inférieurs différents, dans lequel la projection de la fonction théorique sur chacun de ces espaces inférieurs est calculée et dans lequel est utilisée comme fonction approchée la projection dont la différence D avec la fonction théorique F est minimale.

**7.** Filtre adaptatif selon la revendication 6, caractérisé en ce que chaque différence D est déterminée suivant la formule suivante :

$$D = | F - \sum_a \sum_b A_a g^{ab} g_b | .$$

**8.** Filtre adaptatif selon au moins l'une des revendications 1 à 7, dans lequel le filtre élémentaire est une fonction de Gauss avec les paramètres écart type et valeur moyenne.

**9.** Filtre adaptatif selon au moins l'une des revendications 1 à 8, dans lequel le filtre élémentaire est une fonction de Gabor avec les paramètres écart type, valeur moyenne, phase et fréquence.

**10.** Filtre adaptatif selon au moins l'une des revendications 1 à 8, dans lequel le filtre élémentaire correspond à la fonction suivante :

$$g_a(X_i \; ; \; i \in \{1, \; ... \; N\} = \text{sigmoïde} \; (\sum_i W_{ia} \; X_i + \theta) \; ;$$

où $W_{ia}$, θ sont des scalaires correspondant aux paramètres de la fonction de base $g_a$, avec sigmoïde (a) = 1/(1 + $e^{-a}$).

**11.** Filtre adaptatif selon au moins l'une des revendications 1 à 8, dans lequel le filtre élémentaire correspond à la fonction suivante :

$$g_a \; (X_i \; ; \; i \in \{1, ... \; N\} = \tanh \; (\sum_i W_{ia} \; X_i + \theta$$

où $W_{ia}$, θ sont des scalaires correspondant aux paramètres de la fonction de base $g_a$.

**12.** Filtre adaptatif selon au moins l'une des revendications précédentes, dans lequel les filtres élémentaires dépendent linéairement les uns des autres.

**13.** Filtre adaptatif selon au moins l'une des revendications précédentes, dans lequel la fonction théorique est introduite de manière discrète en ce qui concerne le domaine des valeurs aussi bien que la résolution.

**14.** Filtre adaptatif selon au moins l'une des revendications précédentes, dans lequel les réglages paramétriques trouvés sont sortis.

**15.** Filtre adaptatif selon au moins l'une des revendications précédentes, dans lequel la fonction théorique est approchée à des lieux déterminés de manière incomplète, par des valeurs de fonction théorique situées dans la zone environnante, et par un bruit supplémentaire sensiblement gaussien.

**16.** Filtre adaptatif selon au moins l'une des revendications précédentes, dans lequel la méthode de calcul appliquée est une méthode de descente de gradient (déterministej.

**17.** Filtre adaptatif selon au moins l'une des revendications précédentes, dans lequel la fonction théorique F est un signal optique.

**18.** Filtre adaptatif selon au moins l'une des revendications précédentes, dans lequel la fonction théorique F est un signal vidéo.

**19.** Filtre adaptatif selon au moins l'une des revendications précédentes, dans lequel les filtres élémentaires sont des filtres optiques.

**20.** Filtre adaptatif selon au moins l'une des revendications précédentes, dans lequel la fonction théorique est un signal audio.

**21.** Filtre adaptatif selon les revendications 17, 18 ou 19, dans lequel la fonction approchée est transmise en tant que partie d'un signal TV haute densité à largeur de bande réduite.

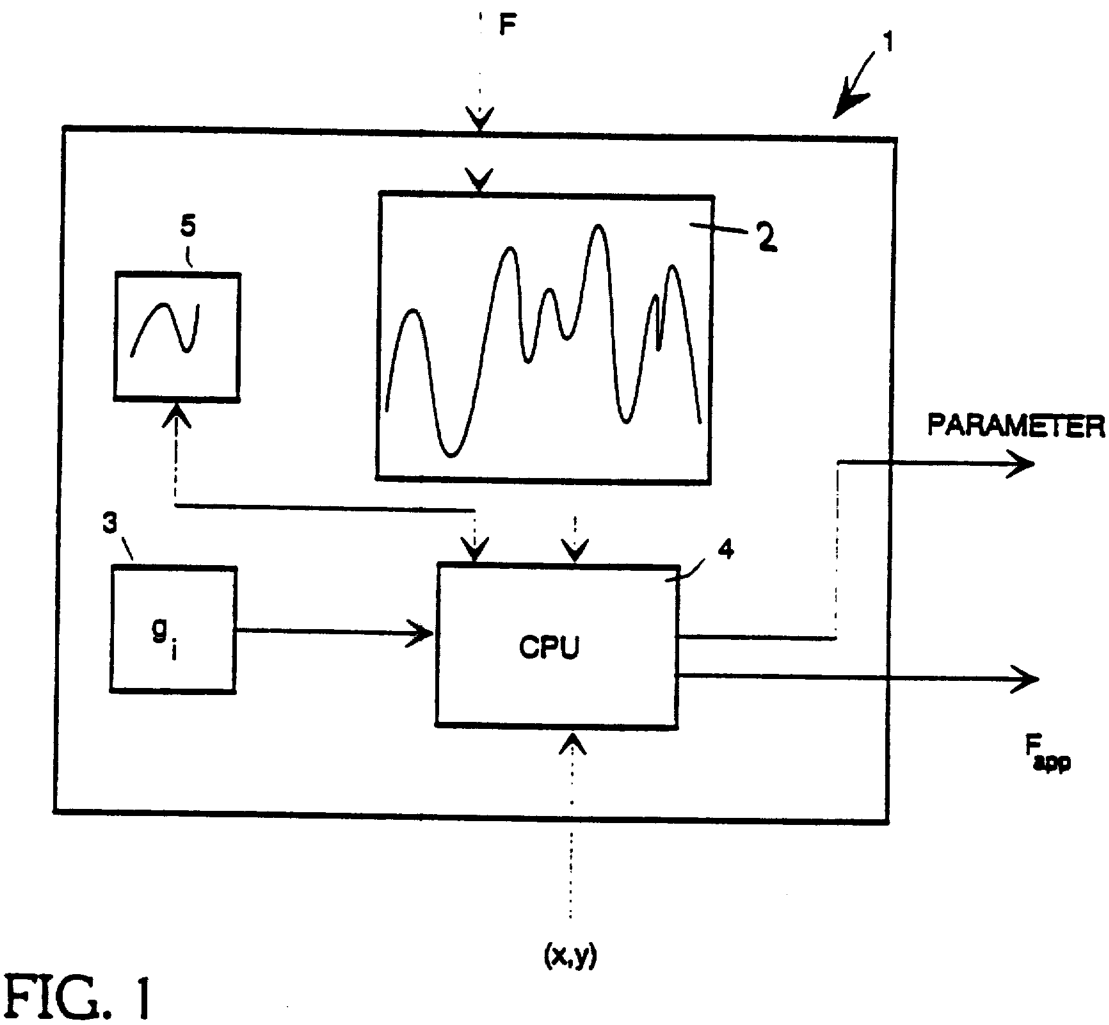


FIG. 1

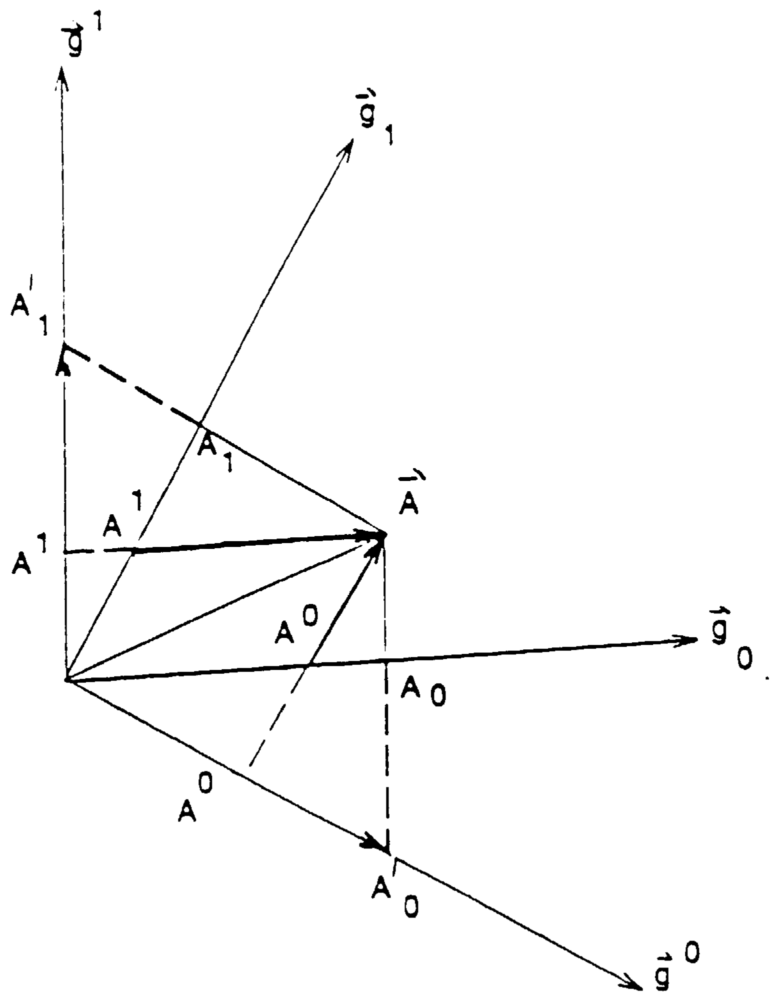


FIG. 2

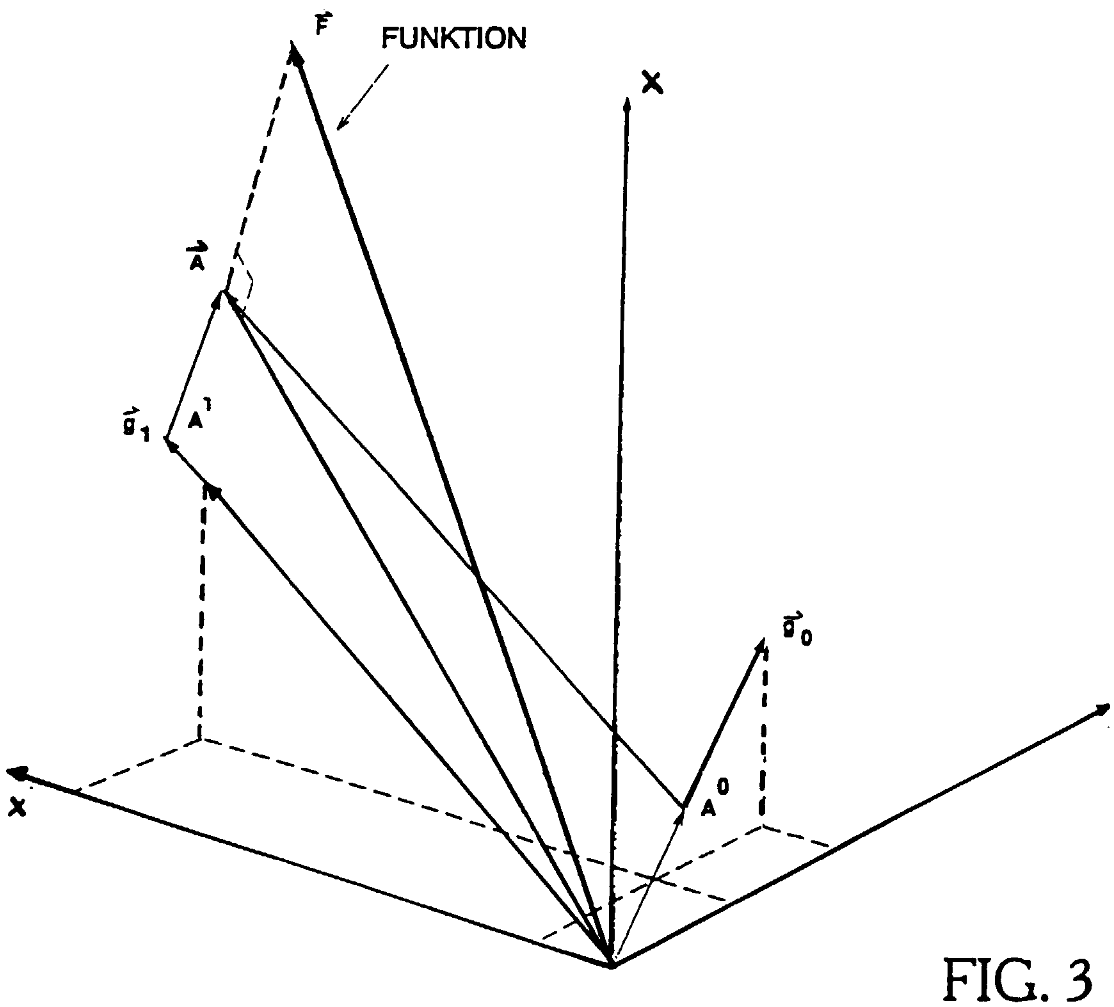


FIG. 3

FIG. 4

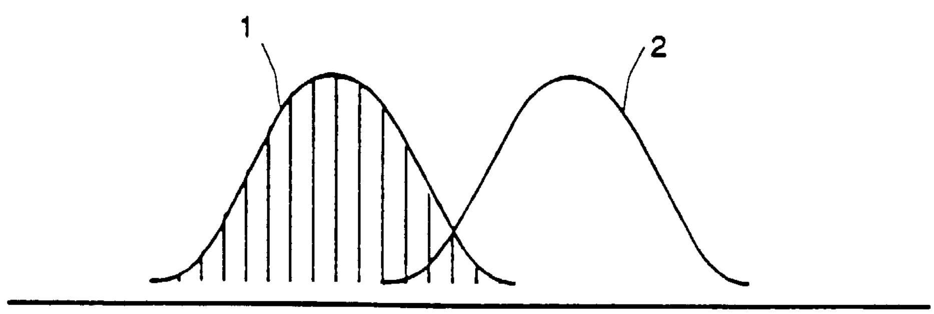

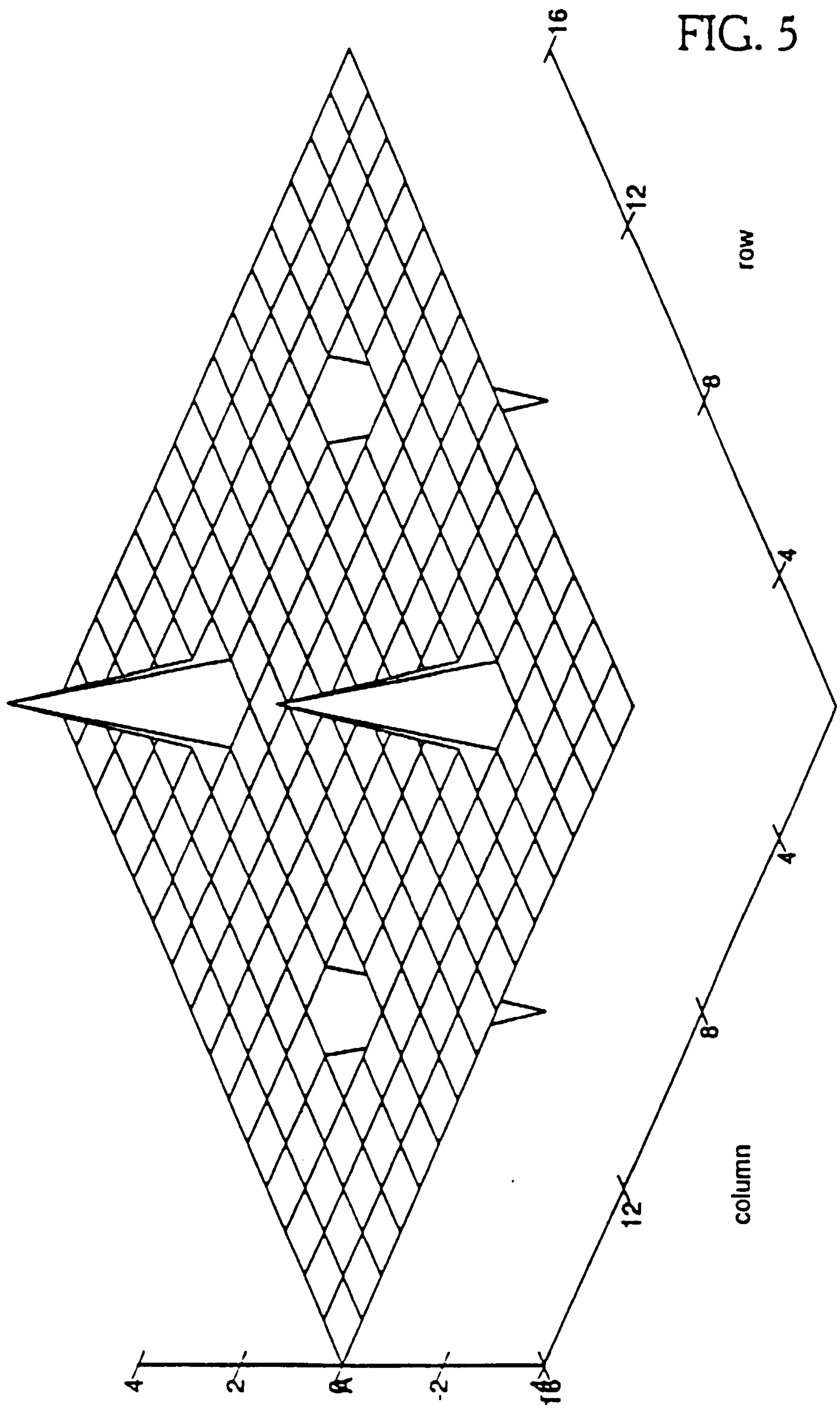


FIG. 5

FIG. 6

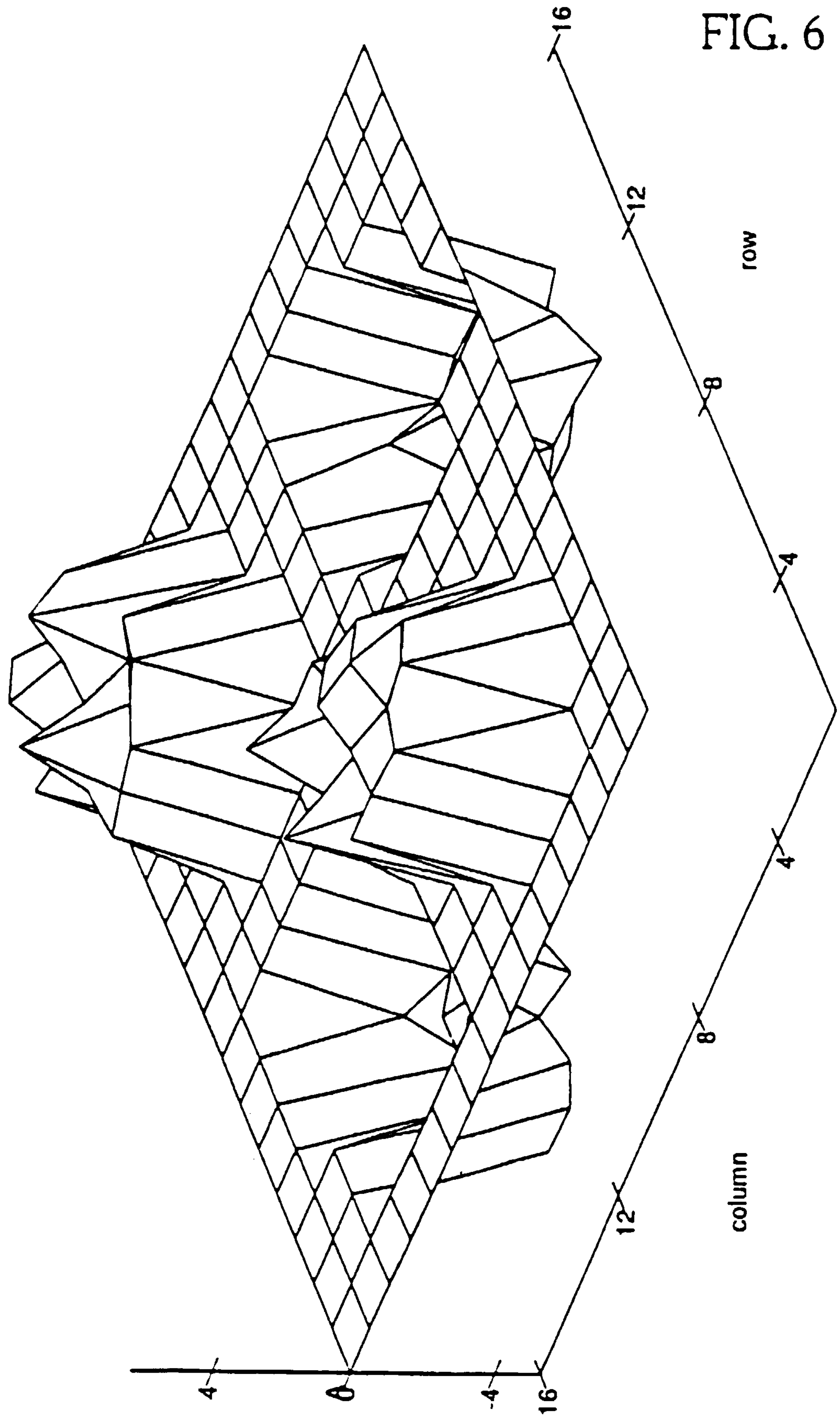

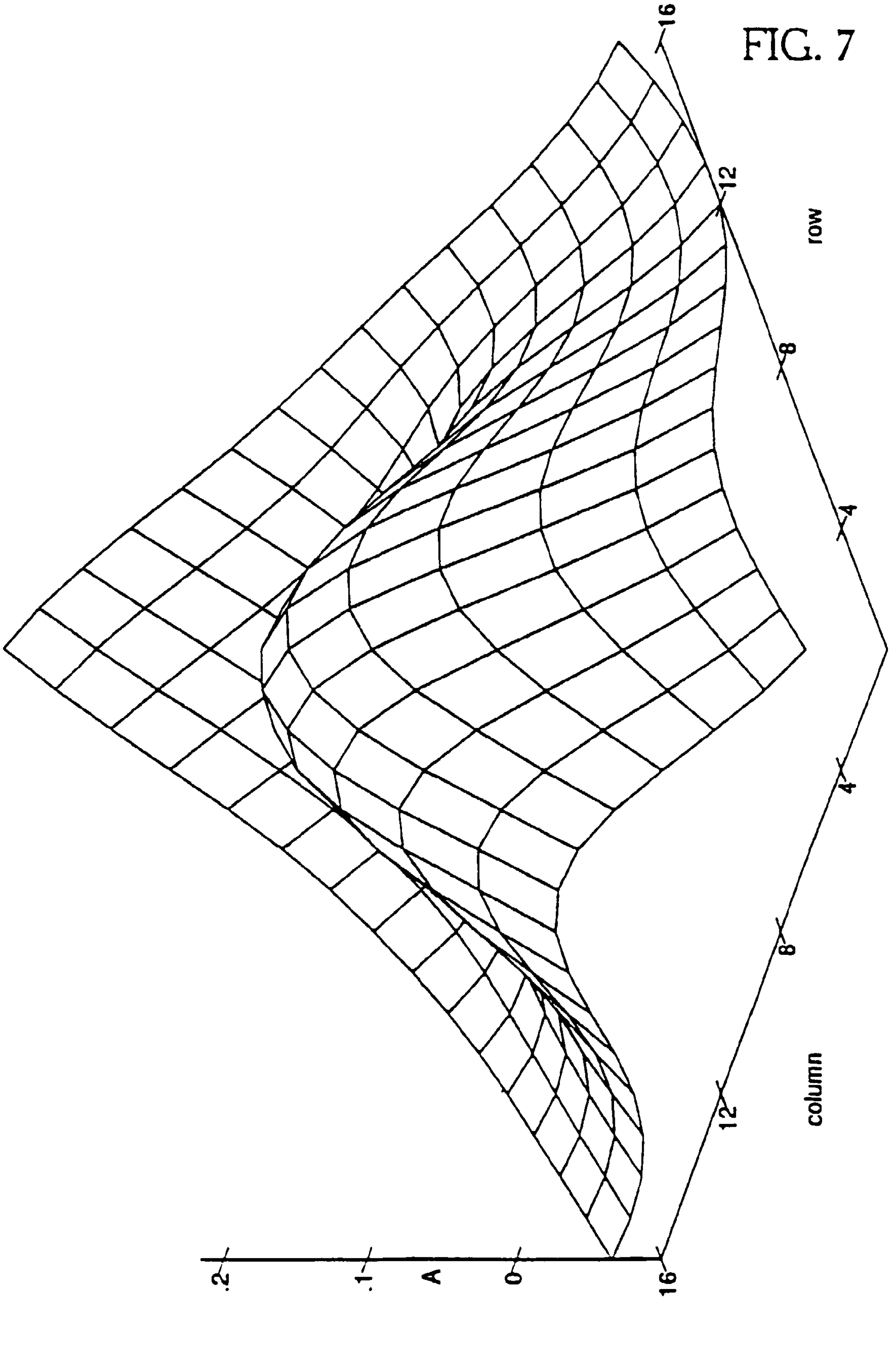


FIG. 7

FIG. 8

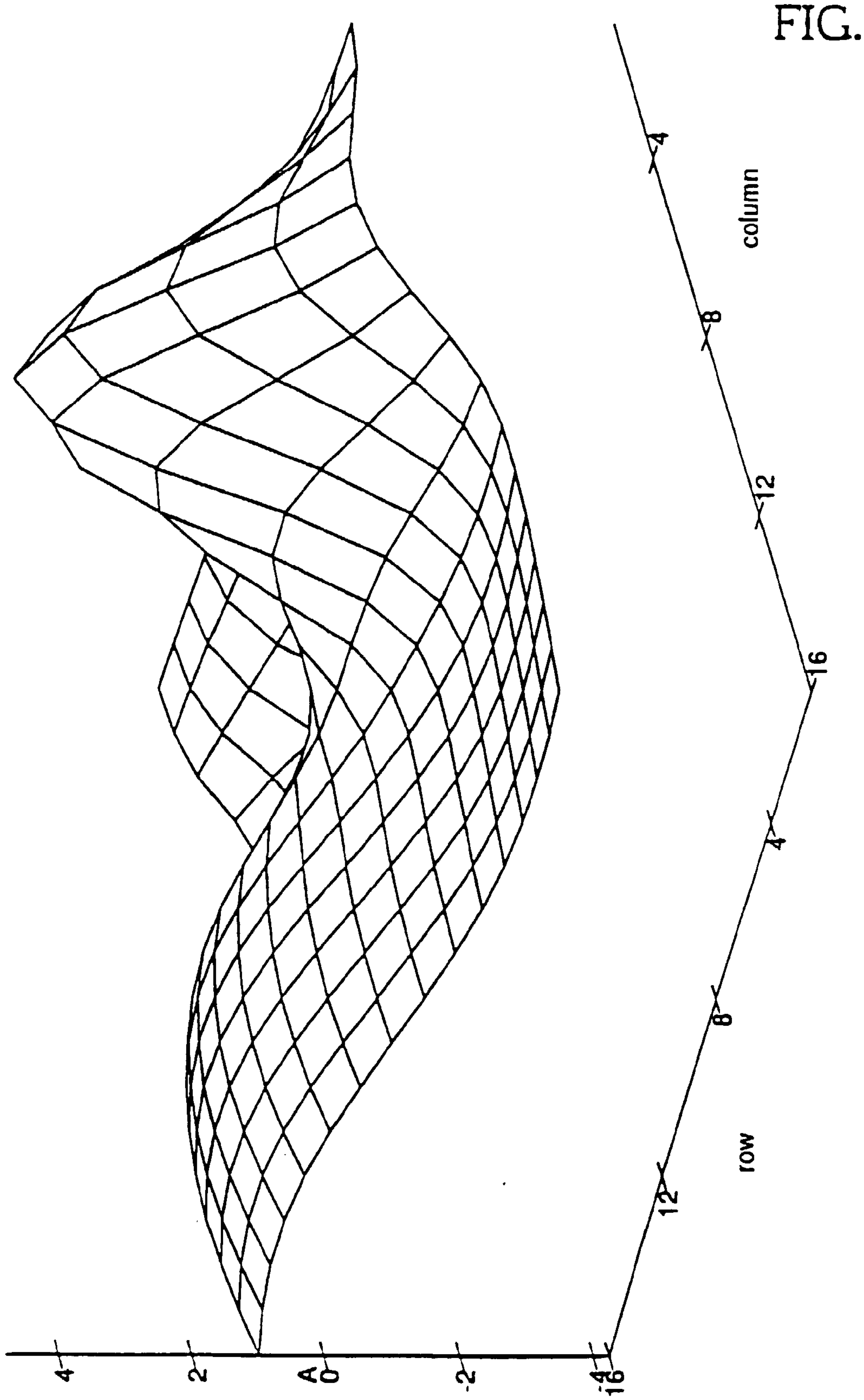

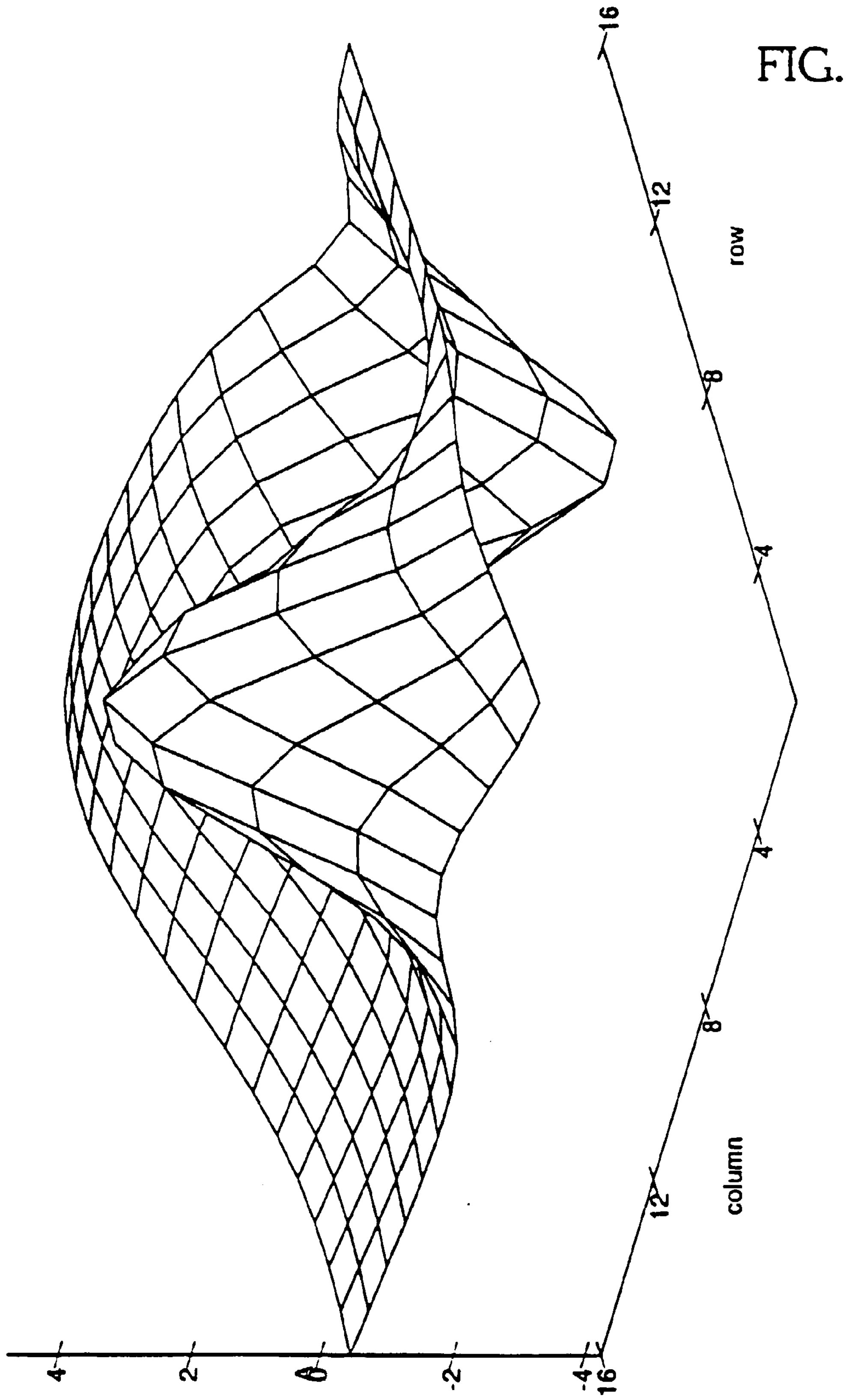


FIG. 9

FIG. 10

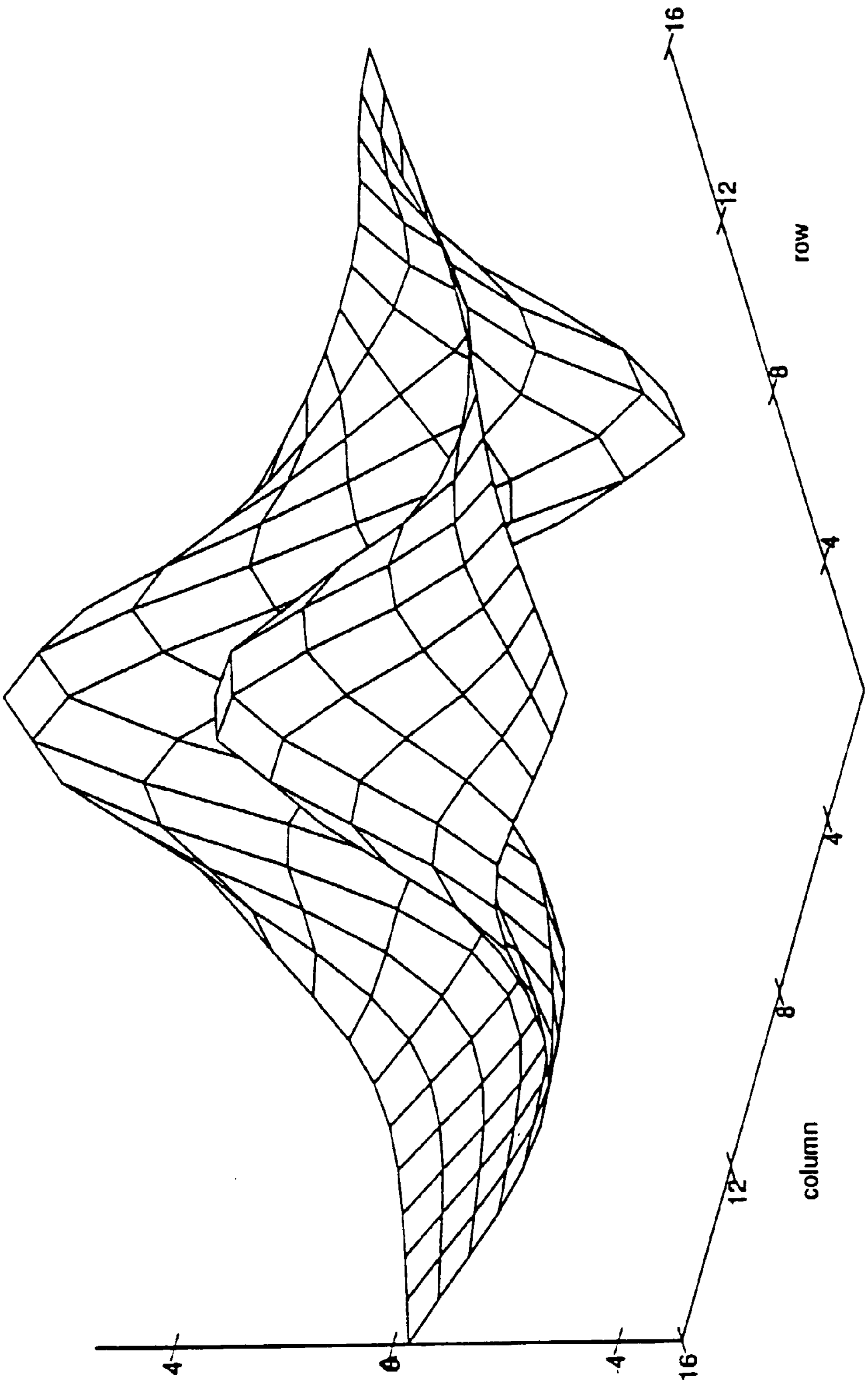

FIG. 11

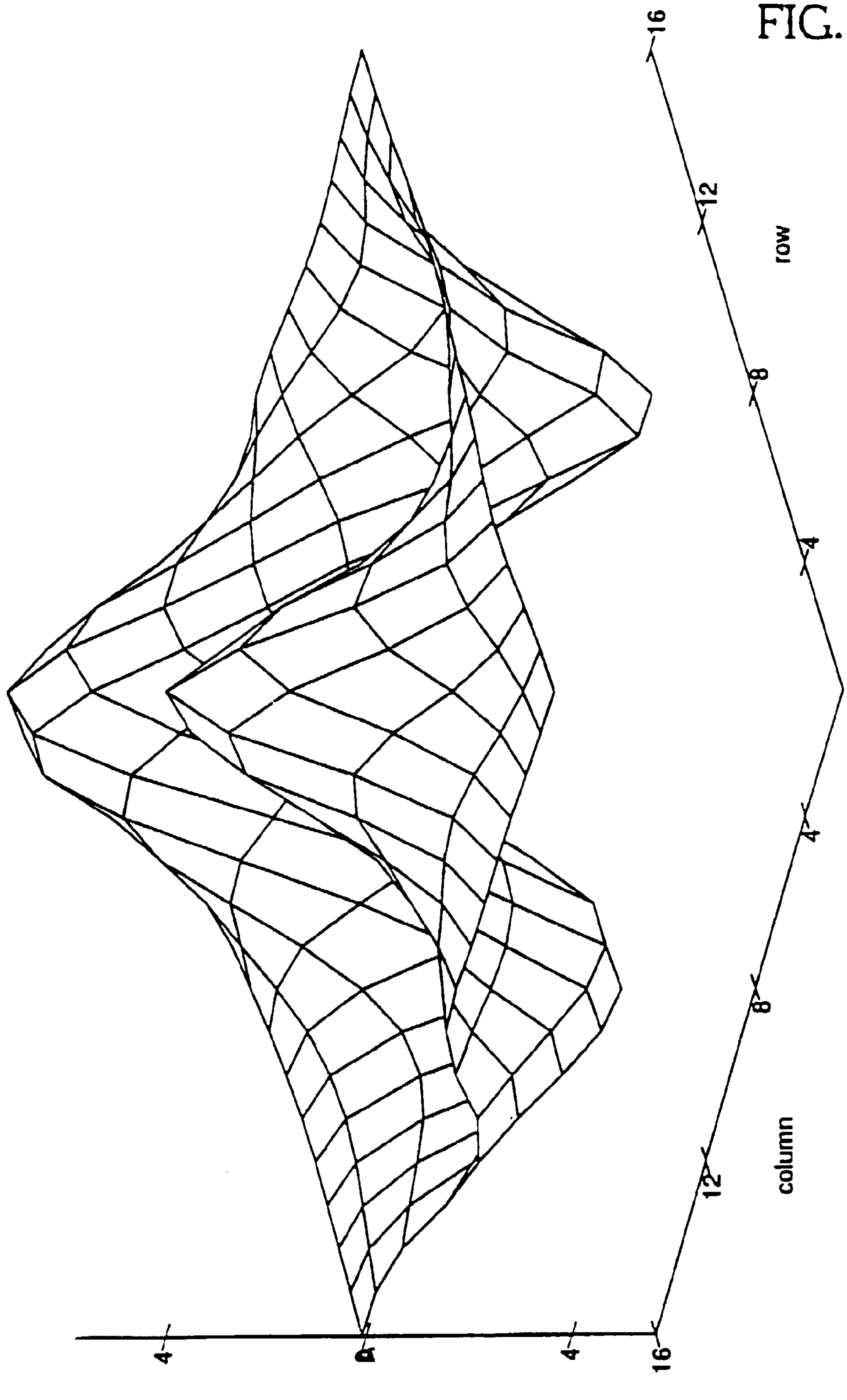

FIG. 12

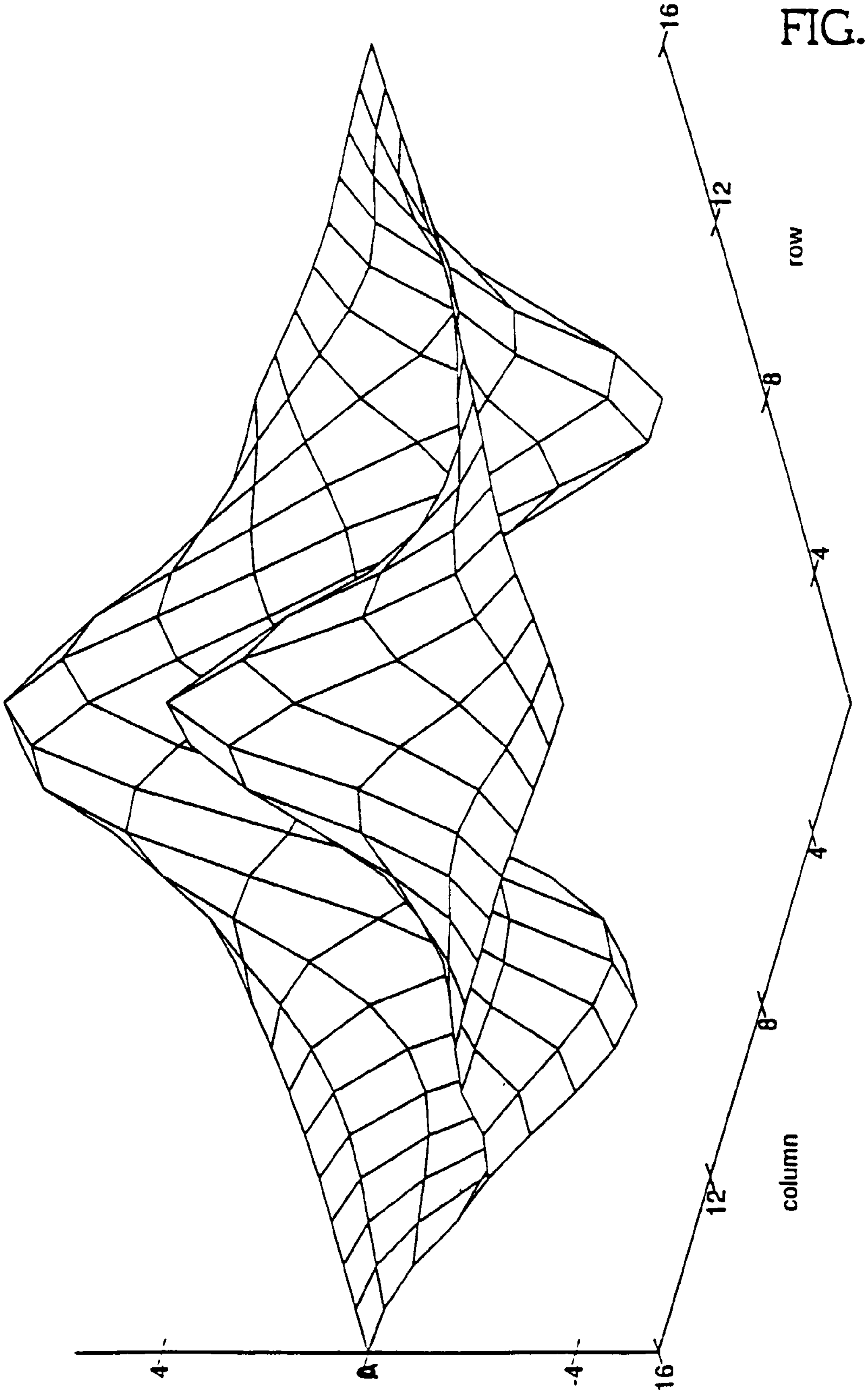

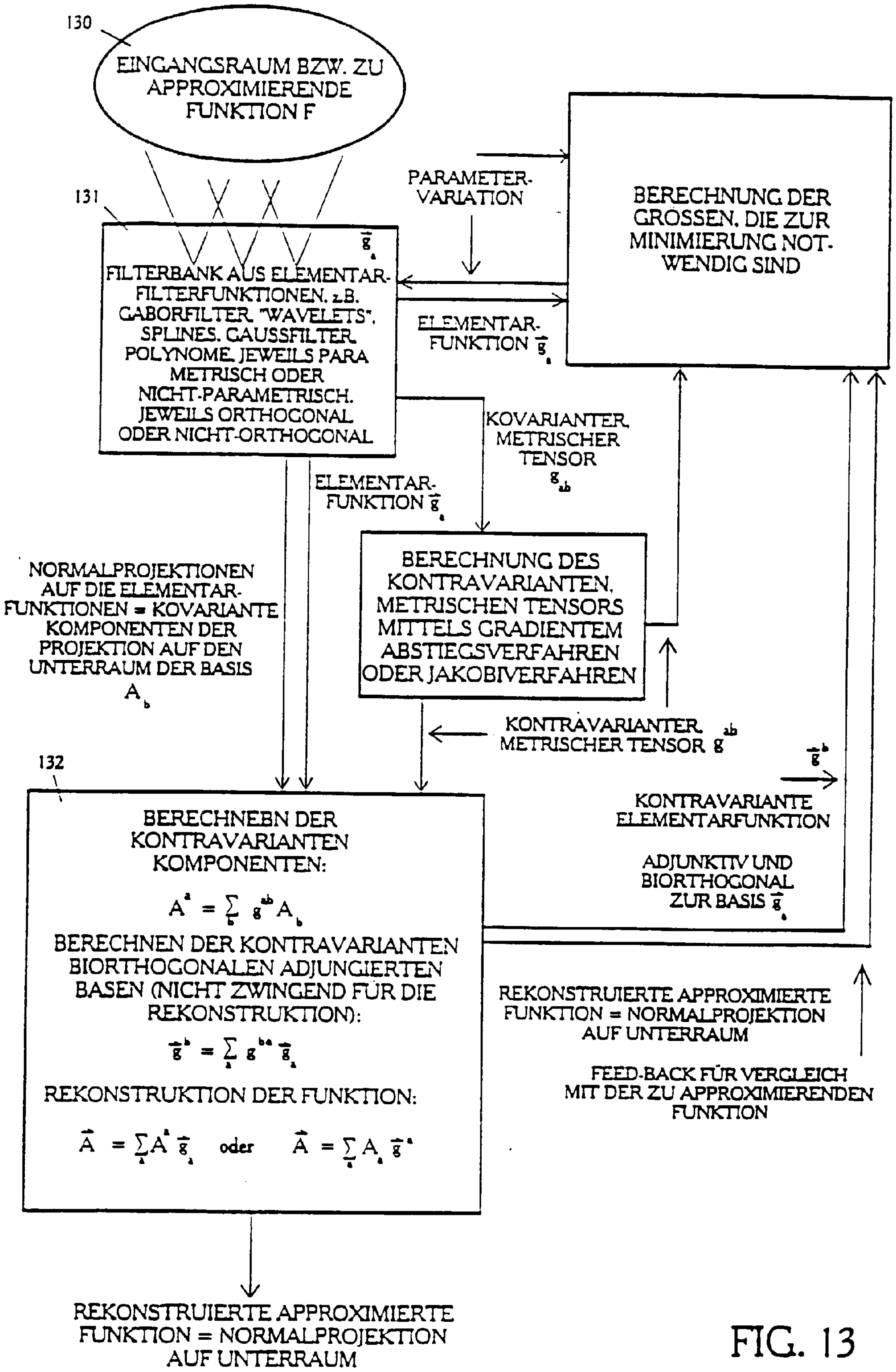
130
EINGANGSRAUM BZW. ZU APPROXIMIERENDE FUNKTION F
131
FILTERBANK AUS ELEMENTAR-FILTERFUNKTIONEN, z.B. GABORFILTER, "WAVELETS", SPLINES, GAUSSFILTER, POLYNOME, JEWEILS PARAMETRISCH ODER NICHT-PARAMETRISCH, JEWEILS ORTHOGONAL ODER NICHT-ORTHOGONAL
PARAMETER-VARIATION
BERECHNUNG DER GROSSEN, DIE ZUR MINIMIERUNG NOTWENDIG SIND
ELEMENTAR-FUNKTION $\vec{g}_a$
KOVARIANTER METRISCHER TENSOR $g_{ab}$
ELEMENTAR-FUNKTION $\vec{g}_a$
NORMALPROJEKTIONEN AUF DIE ELEMENTAR-FUNKTIONEN = KOVARIANTE KOMPONENTEN DER PROJEKTION AUF DEN UNTERRAUM DER BASIS $A_b$
BERECHNUNG DES KONTRAVARIANTEN, METRISCHEN TENSORS MITTELS GRADIENTEM ABSTIEGSVERFAHREN ODER JAKOBIVERFAHREN
KONTRAVARIANTER METRISCHER TENSOR $g^{ab}$
132
$\vec{g}^b$
KONTRAVARIANTE ELEMENTARFUNKTION
ADJUNKTIV UND BIORTHOGONAL ZUR BASIS $\vec{g}_a$
BERECHNEBN DER KONTRAVARIANTEN KOMPONENTEN:
$A^a = \sum_b g^{ab} A_b$
BERECHNEN DER KONTRAVARIANTEN BIORTHOGONALEN ADJUNGIERTEN BASEN (NICHT ZWINGEND FÜR DIE REKONSTRUKTION):
$\vec{g}^b = \sum_a g^{ba} \vec{g}_a$
REKONSTRUKTION DER FUNKTION:
$\vec{A} = \sum_a A^a \vec{g}_a$ oder $\vec{A} = \sum_a A_a \vec{g}^a$
REKONSTRUIERTE APPROXIMIERTE FUNKTION = NORMALPROJEKTION AUF UNTERRAUM
FEED-BACK FÜR VERGLEICH MIT DER ZU APPROXIMIERENDEN FUNKTION
REKONSTRUIERTE APPROXIMIERTE FUNKTION = NORMALPROJEKTION AUF UNTERRAUM

FIG. 13

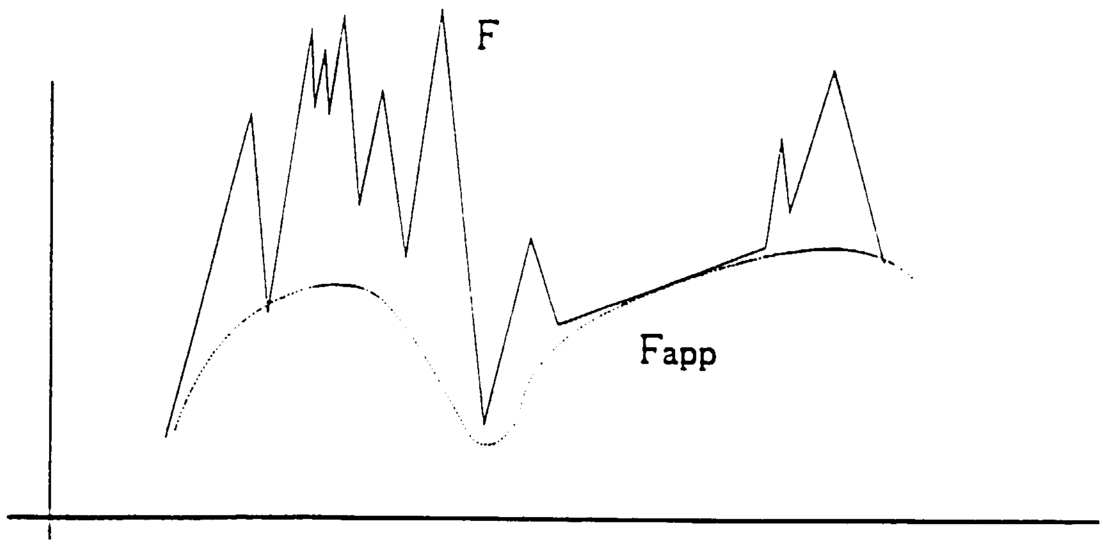


FIG. 14

FILTERSTRUKTUR BEI VERZICHT AUF DIE BERECHNUNG DES KONTRAVARIANTEN METRIKTENSORS

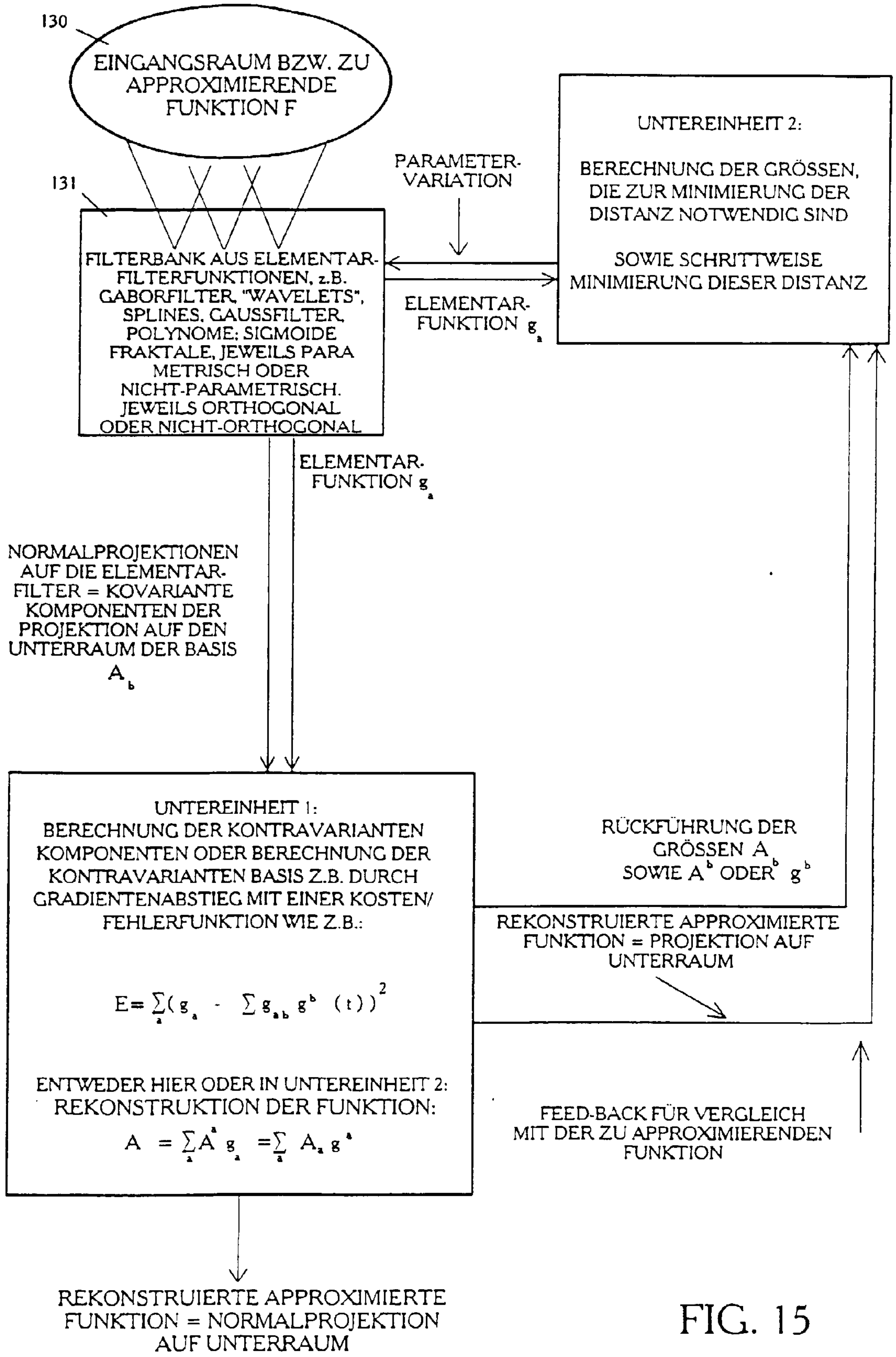


FIG. 15